Europäisches Patentamt

(19) European Patent Office

Office européen des brevets

(11) **EP 0 696 747 A2**

(12) **EUROPEAN PATENT APPLICATION**

(43) Date of publication:
14.02.1996 Bulletin 1996/07

(21) Application number: 95112472.6

(22) Date of filing: 08.08.1995

(51) Int. Cl.⁶: **G02B 6/12**, G02B 6/30,
H01S 3/025, H01L 33/00

(84) Designated Contracting States:
**DE FR GB**

(30) Priority: 12.08.1994 JP 190494/94
07.12.1994 JP 303569/94

(71) Applicant: **MITSUBISHI DENKı KABUSHIKI KAISHA**
**Tokyo 100 (JP)**

(72) Inventors:
• **Kimura, Tatsuya,**
c/o Mitsubishi Denki K.K
1-Mizuhara 4-chome, Itami-shi, Hyogo 664 (JP)

• **Shigihara, Kimio,**
c/o Mitsubishi Denki K.K
1-Mizuhara 4-chome, Itami-shi, Hyogo 664 (JP)
• **Takemoto, Akira,**
c/o Mitsubishi Denki K.K
1-Mizuhara 4-chome, Itami-shi, Hyogo 664 (JP)
• **Mitsui, Shigeru,**
c/o Mitsubishi Denki K.K
1-Mizuhara 4-chome, Itami-shi, Hyogo 664 (JP)

(74) Representative: **KUHNEN, WACKER & PARTNER**
**D-85354 Freising (DE)**

(54) **Integrated semiconductor optical waveguide device and fabrication methode**

(57) In an optical waveguide having one or more quantum well layers, the quantum well layer is put between by cladding layers having smaller refractive indices than that of the quantum well layer, and the quantum well layer having a portion of waveguiding light is put between by cladding layers having smaller refractive indices by disordering of the quantum well layer. Therefore, as compared with a BH (Buried Heterostructure) type or a ridge type optical waveguide, a planar type optical waveguide whose fabrication is easy and processing precision is improved is obtained.

Fig.5 (a)

Printed by Rank Xerox (UK) Business Services
2.9.9/3.4

## Description

FIELD OF THE INVENTION

The present invention relates to a structure and a fabricating method thereof, of an optical integrated device used in such as an optical communication system. In other words, the present invention relates to an optical waveguide, a semiconductor integrated laser and waveguide device, a semiconductor integrated laser, waveguide, and photodiode device, a semiconductor integrated laser, waveguide, mode matching circuit device, mode matching element, and their fabricating methods.

BACKGROUND OF THE INVENTION

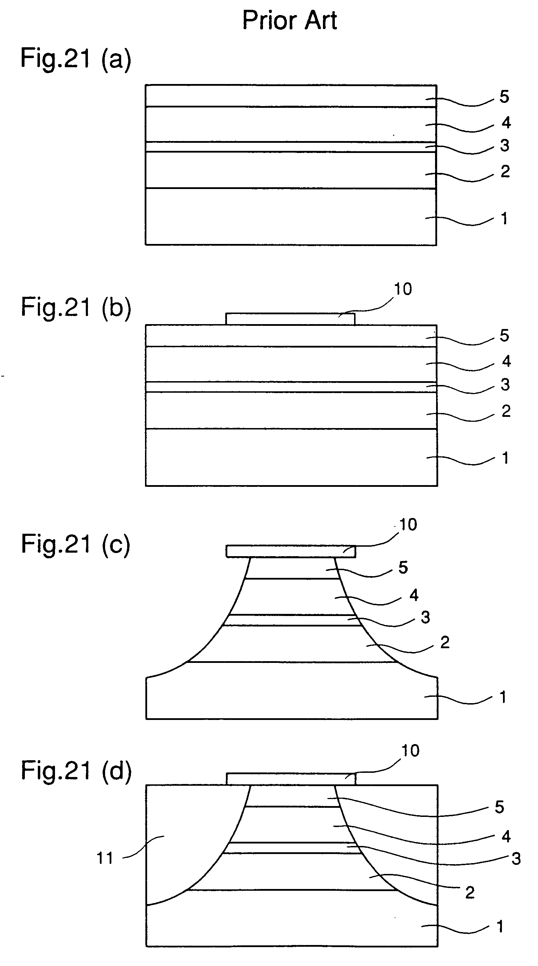

A prior art structure and a fabricating method thereof, of an embedded type optical waveguide of an optical integrated device which has been conventionally used, will be described with reference to figure 21.

As shown in figure 21(a), an n type $Al_{0.48}Ga_{0.52}As$ cladding layer 2, a GaAs/AlGaAs MQW active layer 3, a p type $Al_{0.48}Ga_{0.52}As$ cladding layer 4, and a p type GaAs contact layer 5 are successively grown on the n type GaAs substrate 1 by MOCVD. Here, n type and p type $Al_{0.48}Ga_{0.52}As$ cladding layers 2 and 4 have an impurity concentration of $1 \times 10^{18}cm^{-3}$ and a film thickness of 1.5 μm, and the GaAs/AlGaAs MQW active layer 3 comprises, for example, three GaAs well layers of 80 Å thickness, two $Al_{0.2}Ga_{0.8}As$ barrier layers of 60 Å thickness, and two light confining layers of 700 Å thickness having the same composition as that of the barrier layer, and the p type GaAs contact layer 5 has an impurity concentration of $1 \times 10^{19}cm^{-3}$ and a film thickness of 1 μm.

A silicon dioxide film is formed on the surface by sputtering, and a silicon dioxide film stripe 10 is formed by employing conventional photolithography (figure 21(b)).

Employing the silicon dioxide film stripe 10 as a mask and employing an etching solution comprising tartaric acid, respective semiconductor layers 1 to 5 are etched to form a mesa structure as shown in figure 21(c).

Employing MOCVD method, the high resistance $Al_{0.48}Ga_{0.52}As$ burying layer 11 is selectively grown (figure 21(c)).

Then, because there are provided AlGaAs layers 2, 4, and 11 having lower refractive indices than that of the active layer 3 at the upper and lower sides, and left and right sides of the active layer 3, light is confined in the active layer 3 shown in figure 21(d), thereby presenting an optical waveguide.

In the prior art optical waveguide that is fabricated subsequent to the burying type semiconductor laser, and the fabricating method thereof, because the etching processes of respective semiconductor layers are included, the precise processing was difficult.

In addition, because a difference in level is produced at the element surface through the etching process, the processing precision of the burying growth was low at the epitaxial burying growth of high resistance $Al_{0.48}Ga_{0.52}As$ burying layer 11 in a subsequent process, thereby resulting in a problem that notches are generated.

As for the problem that the fine pattern processing is difficult due to the etching processes, the same does apply to the conventional optical waveguide formed subsequent to the ridge type semiconductor laser.

In order for the output light from the semiconductor not to be absorbed by the optical waveguide when such optical waveguide is to be formed on the same substrate as the semiconductor laser, the semiconductor laser region and the waveguide region has to be grown by separate crystal growth processes.

SUMMARY OF THE INVENTION

It is a first object of the present invention to provide an optical waveguide that can be fabricated easily, has no concavo-convex of the surface of the semiconductor layer, and can enhance the precision in the photolithography process of the surface, and a fabricating method thereof.

It is a second object of the present invention to provide a semiconductor laser and waveguide integrated device in which a semiconductor laser and an optical waveguide are integrated together, and a fabricating method thereof.

It is a third object of the present invention to provide a semiconductor laser - waveguide - photodiode integrated device in which a semiconductor laser, an optical waveguide, and a photodiode are integrated together, and a fabricating method thereof.

It is a fourth object of the present invention to provide a semiconductor laser - a waveguide - a mode matching integrated device in which a semiconductor laser, a waveguide, and a mode matching region for coupling the output of the optical waveguide to an element such as an optical fiber or $LiNbO_3$ are integrated together, and a fabricating method thereof.

It is a fifth object of the present invention to provide a mode matching circuit that can perform mode matching between an optical waveguide and an optical fiber as a single element, and a fabricating method thereof.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, in an optical waveguide having one or more quantum well layers, the quantum well layer is put between by cladding layers having smaller refractive indices than that of the quantum well layer, and the quantum well layer having a portion of waveguiding light is put between by cladding layers having smaller refractive indices by disordering of the quantum well layer. Therefore, as compared with a BH (Buried Heterostructure) type or a ridge type optical waveguide, a planar type optical waveguide whose fabrication is easy and processing precision is improved is obtained.

According to a second aspect of the present invention, the optical waveguide forms a Y branch, a directional coupler, an X cross, a star coupler, or a combination of these. Therefore, the optical waveguides of these types are easily formed.

According to a third aspect of the present invention, a fabricating method of an optical waveguide comprises forming a laminating layer structure including a lower cladding layer, at least one or more quantum well layers and an upper cladding layer by crystal growth on a semiconductor substrate, and forming an optical waveguide which is put between by disordered regions which are formed by disordering required portions of the laminating layer structure including the quantum well layer. Therefore, a planar type optical waveguide whose fabrication is easy and processing precision is improved is obtained because no etching process is required as compared with a BH (Buried Heterostructure) type or a ridge type optical waveguide.

According to a fourth aspect of the present invention, in the above-described fabricating method, the fabricating method of the optical waveguide comprises performing the disordering using a mask having a configuration selected among a Y branch, a directional coupler, an X cross, a star coupler, and a combination of these. Therefore, the optical waveguides of these types are easily formed.

According to a fifth aspect of the present invention, in the integrated semiconductor laser - waveguide device comprising a semiconductor laser region having one or more quantum well active layers and a semiconductor waveguide region having one or more quantum well layers, a quantum well active layer in the semiconductor laser region and portions waveguiding light of the quantum well layer in the waveguide region are put between by cladding layers having smaller refractive indices with the quantum well active layer and the quantum well layer disordered, and waveguide portions in the waveguide region have lager energy band gaps than that of the waveguide portion in the semiconductor laser region by the disordering of the quantum well layer. Therefore, a semiconductor laser and an optical waveguide which do not absorb the output light of the semiconductor are formed together, and as compared with the BH type and the ridge type optical waveguides, a planar type integrated semiconductor laser and waveguide whose fabrication is easy and processing precision is improved is obtained because no etching process is required.

According to a sixth aspect of the present invention, in the above-described integrated semiconductor laser - waveguide device, the waveguide portion of the waveguide region is disordered so as to gradually increase its energy band gap from the side of the semiconductor laser region. Therefore, the planar type semiconductor integrated laser and waveguide device having light intensity distribution that gradually varies, whose fabrication is easy, processing precision is improved, and which has low loss is obtained.

According to a seventh aspect of the present invention, in the above-described integrated semiconductor laser - waveguide device, the cladding portions in the waveguide region are disordered so as to have their refractive indices larger than that of the cladding layer in the semiconductor laser region. Therefore, an integrated semiconductor laser and waveguide device having light intensity distribution that gradually varies, whose fabrication is easy, processing precision is improved, and which has low loss is obtained.

According to an eighth aspect of the present invention, in the above-described integrated semiconductor laser - waveguide device, the cladding portions in the waveguide region are disordered so as to gradually increase their refractive indices from the side of the semiconductor laser region. Therefore, the planar type integrated semiconductor laser and waveguide device having light intensity distribution that gradually varies, whose fabrication is easy, processing precision is improved, and which has low loss is obtained.

According to a ninth aspect of the present invention, in the above-described integrated semiconductor laser - waveguide device, the normalized frequency of the waveguide portion in the disordered waveguide region and the normalized frequency of the waveguide portion in the semiconductor laser region are equal to each other. Therefore, the mode number tolerated in the tapered region coincides with that in the semiconductor laser region, and mode transformation (deformation of the light intensity distribution) is performed smoothly, whereby loss is further decreased.

According to a tenth aspect of the present invention, in the above-described integrated semiconductor laser - waveguide device, the lower cladding layer or the upper cladding layer in the semiconductor laser region includes a grating layer of the distribution feedback type. Therefore, the integrated semiconductor laser and waveguide device can perform laser oscillation by the grating layer of the distribution feedback type.

According to an eleventh aspect of the present invention, the above-described integrated semiconductor laser - waveguide device has a groove that has a vertical side surface between the semiconductor laser region and the waveguide region. Therefore, the integrated semiconductor laser and waveguide device can perform laser oscillation employing the groove as a resonator facet.

According to a twelfth aspect of the present invention, in the above-described integrated semiconductor laser - waveguide device, the groove is filled with a material having a smaller refractive index than the effective refractive index of the active layer of the semiconductor laser. Therefore, the integrated semiconductor laser and waveguide device can perform laser oscillation employing the groove as a resonator facet as well as can change its reflectance arbitrarily.

According to a thirteenth aspect of the present invention, an integrated semiconductor laser - waveguide device comprises successively growing a lower cladding layer, a quantum well layer, an upper cladding layer and a contact layer on a semiconductor substrate, disordering a portion serving as a cladding portion of the quantum well layer by performing ion implantation and diffusion to portions serving as cladding portions of the semiconductor laser region and the waveguide region, disordering a waveguide portion of the quantum well layer to a ratio smaller than that of the cladding portion by performing ion implantation and diffusion to a waveguide portion of the waveguide region. Therefore, a planar type integrated semiconductor laser and waveguide device that enables easy fabrication and increased processing precision is obtained because no etching process is required as compared with the BH type or the ridge type optical waveguide.

According to a fourteenth aspect of the present invention, in the above-described fabricating method of the integrated semiconductor laser and waveguide device, the process of disordering the cladding portion or the waveguide portion comprises disordering the quantum well layer by performing ion implantation into a portion where the disordering is to be performed of the cladding portion or the waveguide portion, and gradually disordering the remaining region other than a portion where the disordering is to be performed by performing ion implantation and diffusion once or several times. Therefore, the integrated semiconductor laser and waveguide device which has regions in which the refractive index and the energy band gap are adjusted precisely, those values gradually vary and which are easily formed is obtained.

According to a fifteenth aspect of the present invention, an integrated semiconductor laser - waveguide - photodiode device comprising a semiconductor laser region having one or more quantum well active layers, a waveguide region having one or more quantum well layers, a photodiode region which is formed successively to the semiconductor laser region and the waveguide region and functions as a photodiode with a reverse bias applied to the pn junction in the layers including the quantum well layer, which are commonly formed on a substrate, both sides of portions waveguiding light, of the quantum well active layer in the semiconductor laser region and the quantum well layer in the waveguide region are sandwiched by cladding portions having smaller refractive indices by disordering the quantum well active layer and the quantum well layer, and the energy band gap of the waveguide portion in the waveguide region is larger than that of the waveguide portion in the semiconductor laser region due to the disordering. Therefore, as compared with the BH type or the ridge type one, the planar type integrated semiconductor laser, waveguide, photodiode device in which the semiconductor laser, the waveguide not absorbing the output light of the semiconductor laser, and the photodiode are formed integrated and which provides has easy fabrication and improved processing precision is obtained.

According to a sixteenth aspect of the present invention, a method of fabricating an integrated semiconductor laser - waveguide - photodiode device having a semiconductor laser region, a waveguide region, and a photodiode region on a same substrate comprises successively growing a lower cladding layer, a quantum well layer, an upper cladding layer, and a contact layer on the substrate, disordering the quantum well layer of the cladding portion in the semiconductor laser region and in the waveguide region by performing ion implantation and diffusion to the cladding portion of those regions, disordering the quantum well layer in the waveguide region in a smaller ratio than that of the cladding portion by performing ion implantation and diffusion to the waveguide portion in the waveguide region, forming respective lower electrodes or a common lower electrode in the semiconductor laser region and in the photodiode region, and forming upper electrodes in the semiconductor laser region and in the photodiode region, respectively. Therefore, a planar type integrated semiconductor laser - waveguide - photodiode device in which the waveguide not absorbing the output light from the semiconductor laser, the semiconductor laser, and the photodiode are formed together that enables easy fabrication and increased processing precision because no etching process is required as compared with the BH type or the ridge type one is obtained.

According to a seventeenth aspect of the present invention, an integrated semiconductor laser - waveguide - mode matching circuit device comprises a semiconductor laser region having one or more quantum well active layers, a waveguide region having one or more quantum well layers, and a mode matching region having at least one or more quantum well layers and performing mode-matching, which are formed integrated on a substrate. The both sides of the portions waveguiding light, of the quantum well active layer in the semiconductor laser region and of the quantum well layers in the waveguide region and in the mode matching region are sandwiched by the cladding portions having smaller refractive indices due to the disordering of the quantum well active layer and the quantum well layer. The waveguide portions in the waveguide region and in the mode matching region are disordered so as to have larger energy band gaps than that of the waveguide portions in the semiconductor laser region. The waveguide portion in the mode matching region is formed in a tapered shape. Therefore, the integrated semiconductor laser - waveguide - mode matching circuit device whose fabrication is easy and processing precision is improved as compared with the BH type or the ridge type is obtained. The coupling of light with an optical fiber, LiNbO3, or the like which will be connected behind (deformation of light intensity distribution) is performed in a large spot size without generating multi modes.

According to an eighteenth aspect of the present invention, the above-described integrated semiconductor laser - waveguide - mode matching circuit device comprises a first lower cladding layer, a second lower cladding layer, the quantum well layer, a second upper cladding layer, and a first upper cladding layer. The second upper cladding layer and the lower cladding layer comprise materials having smaller refractive indices than that of the first upper cladding layer and that of the first lower cladding layer, respectively. Additionally to respective disordered portions, only the second upper cladding layer and the second lower cladding layer of the waveguide portion in the mode matching region are intensively disordered. Therefore, a planar type integrated semiconductor laser - waveguide - mode matching circuit device whose fabrication is easy and processing precision is improved is obtained. Moreover, the spot size is expanded in both the X axis direction (the crystal growth direction) and the Y axis direction, so that the connection with the optical fiber and LiNbO$_3$ is performed without generating multi modes and with deformation of the light intensity distribution.

According to a nineteenth aspect of the present invention, in the above-described integrated semiconductor laser - waveguide - mode matching circuit device, the waveguide portion in the mode matching region is formed expanding in a tapered shape. Therefore, the connection of light with the optical fiber and LiNbO$_3$ which will be connected behind (deformation of the light intensity distribution) is performed in large spot size without generating multi modes.

According to a twentieth aspect of the present invention, in the above-described integrated semiconductor laser - waveguide - mode matching circuit device, the waveguide portion in the mode matching region is formed being narrowed in a tapered shape. Therefore, since the width of a core portion is made to a predetermined size, the connection with the optical fiber and LiNbO$_3$ is performed without generating multi modes.

According to a twenty-first aspect of the present invention, in the above-described integrated semiconductor laser - waveguide - mode matching circuit device, the normalized frequency of the waveguide portion in the waveguide region and that in the mode matching region are equal to each other. Therefore, the mode number tolerated in tapered region coincides with that in LD region, so that the mode transformation (deformation of the light intensity distribution) is performed smoothly, and loss is reduced.

According to a twenty-second aspect of the present invention, in the above-described integrated semiconductor laser - waveguide - mode matching circuit device, the waveguide portion in the mode matching region is expanded in tapered shape. Therefore, the connection with the optical fiber and LiNbO$_3$ is performed with enlarging the spot size, so that deformation and connection of the light intensity distribution is performed without generating multi modes. In other words, the width of the core in the mode matching region is expanded, and difference in the refractive index between the core portion and the cladding portion is reduced by the expanding width of the core so that the normalized frequency V1 in the waveguide region and that V2(Z) in the matching region always coincides each other. Thereby, the mode transformation is performed smoothly without generating multi mode.

According to a twenty-third aspect of the present invention, in the above-described integrated semiconductor laser - waveguide - mode matching circuit device, the waveguide portion in the mode matching region is narrowed in tapered shape. Therefore, the mode number tolerated in the tapered region becomes single mode with certainty. Thereby, mode transformation is performed smoothly, and the loss is reduced.

According to a twenty-fourth aspect of the present invention, a method for fabricating an integrated semiconductor laser - waveguide - mode matching circuit device having a semiconductor laser region, a waveguide region, and a mode matching region on a substrate comprises successively growing a lower cladding layer, a quantum well layer, an upper cladding layer, and a contact layer on a semiconductor substrate, performing ion implantation to portions serving as cladding portions, of the semiconductor laser region and the waveguide region thereby to disorder the portion of the quantum well layer, after forming a mask having a taper-shaped aperture at a portion serving as the cladding portion in the mode matching region, performing ion implantation through this mask, thereby to disorder the quantum well layer of the portion, performing ion implantation to the waveguide portion in the waveguide region, thereby to disorder the quantum well layer of the waveguide portion in a smaller ratio than the disordering of the cladding portion, after forming a mask having a taper-shaped aperture at a portion serving as a waveguide portion in the mode matching region, performing ion implantation through this mask, thereby to disorder the quantum well layer of the waveguide portion in a smaller ratio than the disordering of the cladding portion. Therefore, an integrated semiconductor laser - waveguide - mode matching circuit device whose fabrication is easy and processing precision is improved as compared with the BH type or the ridge type is obtained, and the connection of light (the deformation of light intensity distribution) with the optical fiber and LiNbO$_3$ which will be connected behind is performed in large spot size without generating multi modes.

According to a twenty-fifth aspect of the present invention, in the above-described fabricating method of the integrated semiconductor laser - waveguide - mode matching circuit device, the above-described growth process is the process of growing the first lower cladding layer, the second lower cladding layer, the quantum well layer, the second upper cladding layer, the first upper cladding layer, and the contact layer on a substrate, where the second upper cladding layer and the second lower cladding layer have different refractive indices from those of the first upper cladding layer and the first lower cladding layer, respectively, and the process of disordering the waveguide portion in the mode matching region includes a process of disordering only both of the second upper cladding layer and the second lower cladding layer, additionally disordering the disordering. Therefore, the connection of light with the optical fiber and LiNbO$_3$ is performed with enlarging the spot size in both the X axis direction and the Y axis direction without generating multi modes and with deformation of the light intensity distribution.

According to a twenty-sixth aspect of the present invention, in the above-described fabricating method of the integrated semiconductor laser - waveguide - mode matching circuit device, the process of disordering the mode matching region is a process of disordering the same so that the normalized frequencies in the waveguide region and in the mode matching region coincide with each other. Therefore, the mode number tolerated in the waveguide region is equalized with that in the mode matching region, whereby the mode transformation (deformation of the light intensity distribution) is performed smoothly, and loss is reduced.

According to a twenty seventh aspect of the present invention, a mode matching element for converting the mode of input light to output light includes a first lower cladding layer, a second lower cladding layer, a light guiding layer, a quantum well layer, a light guiding layer, a second upper cladding layer, and a first upper cladding layer which are successively formed on the substrate, where the second upper cladding layer and the second lower cladding layer have different refractive indices from those of the first upper cladding layer and the first lower cladding layer, respectively, and a cap layer formed on the center of the upper cladding layer and having a larger refractive index than that of the first upper cladding layer, current blocking layers provided sandwiching the cap layer at both sides on the first cladding layer and having a smaller refractive index than that of the first blocking layer, and a contact layer provided on the upper first cladding layer and the current blocking layer. The portions of the second upper cladding layer and the second lower cladding layer are disordered. Therefore, a mode matching element as a simple substance which performs mode-matching between the optical waveguide and the optical fiber or LiNbO$_3$, and enlarges the spot size also in the X axis direction is obtained.

According to a twenty-eighth aspect of the present invention, the method for fabricating a mode matching element for converting the mode of input light to output light includes successively growing a first lower cladding layer, a second lower cladding layer, a light guiding layer, a quantum well layer, a light guiding layer, a second upper cladding layer, a first upper cladding layer, a cap layer, where the second upper cladding layer and the second lower cladding layer have different refractive indices from those of the first upper cladding layer and the first lower cladding layer, respectively, after etching both sides of the cap layer, growing blocking layers at both sides thereof, and growing a contact layer thereon, performing ion implantation to the second lower cladding layer and the second upper cladding layer, and performing annealing, thereby to disorder the second upper cladding layer and the second lower cladding layer. Therefore, a simple substance mode matching element is produced with high precision through an easy process.

BRIEF DESCRIPTION OF THE DRAWINGS

Figures 1(a)-1(d) are sectional views illustrating a fabricating method of an optical waveguide according to a first embodiment of the present invention, and figure 1(d) is a diagram showing solid phase ratio of Al in the active region before and after the disordering.

Figures 2(a)-2(e) are sectional views illustrating fabricating process steps of the optical waveguide according to an alternative of the first embodiment of the present invention.

Figures 3(a)-3(c) are plan views illustrating a waveguide device according to a second embodiment of the present invention.

Figures 4(a)-4(c) are a plan view (figure 4(a)), a 4b-4b sectional view of figure 4(a) (figure 4(b)), a 4c-4c sectional view (figure 4(c)), respectively, of a third embodiment of the present invention.

Figures 5(a) and 5(b) are a perspective view and a sectional view, respectively, of an integrated semiconductor laser and waveguide device according to a fourth embodiment of the present invention.

Figures 6(a)-6(c) are a diagram illustrating refractive index distribution in a cross-section of a cladding portion (figure 6(a)), a diagram illustrating refractive index distribution and light intensity distribution in the X-Y cross-section of the semiconductor laser region (figure 6(b)), and a diagram illustrating refractive index distribution and light intensity distribution in the X-Y cross-section of the waveguide region(figure 6(c)), respectively, in a connecting structure between a semiconductor laser and a waveguide according to a fourth aspect of the present invention.

Figures 7(a) and 7(b) are a perspective view illustrating a connecting structure between a semiconductor laser and a waveguide and a diagram illustrating refractive index distribution of a core portion in the connecting structure between the semiconductor laser and the waveguide, respectively, in an integrated semiconductor laser and waveguide device according to a fifth embodiment of the present invention.

Figures 8(a) and 8(b) are a diagram illustrating refractive index distribution in the X-Y cross-section in the semiconductor laser region and a diagram illustrating refractive index distribution in the X-Y direction in the tapered region of the waveguide region, respectively, in an integrated semiconductor laser and waveguide device according to a fifth embodiment of the present invention.

Figure 9(a)-9(d) are diagrams illustrating fabricating process steps of an integrated semiconductor laser and waveguide device according to a seventh embodiment of the present invention.

Figure 10 is a sectional view in X-Z plane of the core region of an integrated semiconductor laser and waveguide device according to an eighth embodiment of the present invention.

Figures 11(a)-11(d) are a plan view (figure 11(a)), a 11b-11b sectional view (figure 11(b)), a 11c-11c sectional view (figure 11(c)), and a 11d-11d sectional view (figure 11(d)), respectively, of an integrated semiconductor laser - waveguide - photodiode device according to a tenth embodiment of the present invention.

Figure 12 is a perspective view illustrating a connecting structure of the LD region, the waveguide, and the mode matching region in the integrated semiconductor laser, waveguide, and mode matching device according to a twelfth embodiment of the present invention.

Figures 13(a) and 13(b) are a perspective view illustrating a connecting structure of an LD, waveguide, and mode matching region and a diagram illustrating a relation between the spot size of the light intensity distribution of a near field pattern and width of a core portion, respectively, in an integrated semiconductor laser - waveguide - mode matching circuit device according to a twelfth embodiment of the present invention.

Figures 14(a)-14(g) are diagrams illustrating fabricating process steps of the integrated semiconductor laser - waveguide - mode matching circuit device according to a thirteenth embodiment of the present invention.

Figures 15(a)-15(c) are a perspective view illustrating a mode matching element according to a fourteenth embodiment of the present invention (figure 15(a)), a diagram illustrating refractive index distribution of $Z_A$-$Z_B$ cross-section and light intensity distribution thereof, and a diagram illustrating refractive index distribution of $Z_C$-$Z_D$ cross-section and light intensity distribution thereof, respectively.

Figure 16 is a diagram illustrating a state of using a mode matching circuit according to a fourteenth embodiment of the present invention.

Figures 17(a) and 17(b) are diagrams illustrating fabricating process steps of the mode matching element according to a fifteenth embodiment of the present invention.

Figure 18 is a perspective view illustrating a connecting structure of the LD region, the waveguide region, and the mode matching region in the integrated semiconductor laser - waveguide - mode matching circuit according to a sixteenth aspect of the present invention.

Figure 19 is a perspective view illustrating a connecting structure of the LD region, the waveguide region, mode matching region in the integrated semiconductor laser - waveguide - mode matching circuit according to a seventeenth embodiment of the present invention.

Figures 20(a)-20(c) are diagrams illustrating fabricating process steps for fabricating the integrated semiconductor laser - waveguide - mode matching circuit device according to an eighteenth aspect of the present invention.

Figures 21(a)-21(d) are sectional views illustrating fabricating process steps of the waveguide of the prior art device.

Figure 22 is a plan view illustrating an optical integrated circuit according to the prior art.

Figure 23 is a sectional view in X-Z plane of the core region of an integrated semiconductor laser and waveguide device according to the ninth embodiment of the present invention.

DETAILED DESCRIPTION OF THE PREFERRED EMBODIMENTS

Embodiment 1.

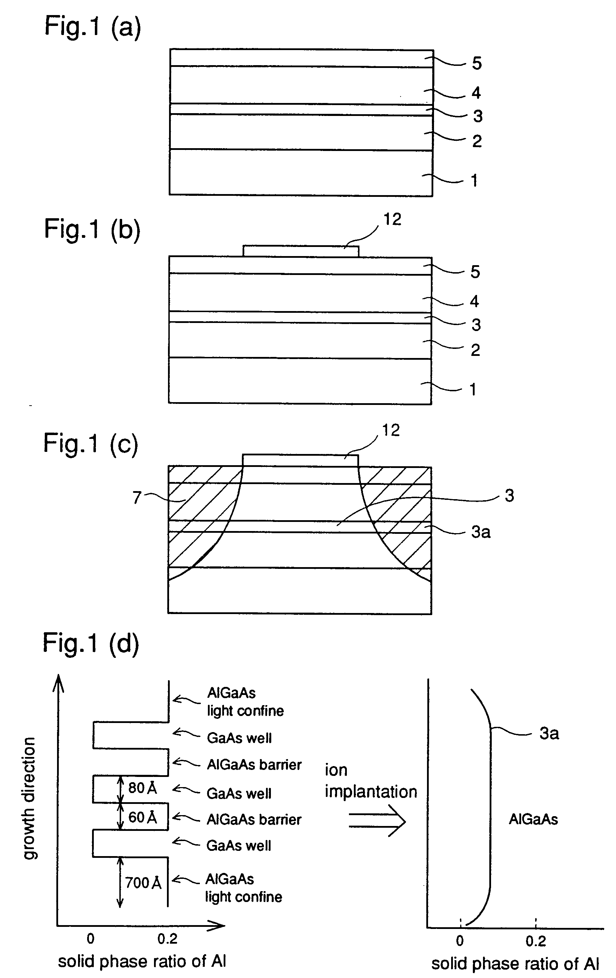

A description is given of a fabricating method of an optical waveguide according to a first embodiment of the present invention with reference to figure 1.

First of all, as in the prior art example shown in figure 21(a), on an n type GaAs substrate 1, a double heterostructure crystal comprising an n type $Al_{0.48}Ga_{0.52}As$ cladding layer 2, a GaAs/AlGaAs MQW active layer 3, a p type $Al_{0.48}Ga_{0.52}As$ cladding layer 4, and a p type GaAs contact layer 5 are grown by MOCVD (figure 1(a)). Here, as in the prior art example of figure 21(a), the n and p type $Al_{0.48}Ga_{0.52}As$ cladding layers 2 and 4 have impurity concentration of 1 x $10^{18}cm^{-3}$ and a film thickness of 1.5 μm, and the GaAs/AlGaAs MQW active layer 3 has, for example, three 80 Å thickness GaAs well layers and two 60 Å thickness $Al_{0.2}Ga_{0.8}As$ barrier layers, two light confinement layers of 700 Å thick comprising the same composition as the barrier layers putting between these five layers, and the p type GaAs contact layer 5 has an impurity concentration of 1 x $10^{19}cm^{-3}$ and a film thickness of 1 μm.

The resist 12 is formed in a stripe shape by employing conventional photolithography (shown in figure 1(b)).

Next, silicon ions (or Al, Ga, Zn, or Be ions) are implanted into the respective semiconductor layers 1 to 5 using the resist 12 as a mask as shown in figure 1(c), thereby forming a region 7, and then annealing is performed.

In this way, the MQW active layer 3 at the ion implanted region 7 becomes a bulk AlGaAs by the MQW structure being destroyed by the movement of Al that is caused by the ion implantation as shown in figure 1(d), this phenomenon being called as disordering. The refractive index of this bulk AlGaAs layer 3a presents a value smaller than that of the GaAs well layer of the MQW active layer 3 by mixture crystallization of Al in the light confinement layer and the GaAs layer. Accordingly, in the structure of figure 1(c), the active layer 3 that remains in the state of MQW structure without being disordered, serves as an optical waveguide.

An alternative of a method of fabricating an optical waveguide employing disordering using ion implantation as described above is illustrated in the following.

Alternative 1.

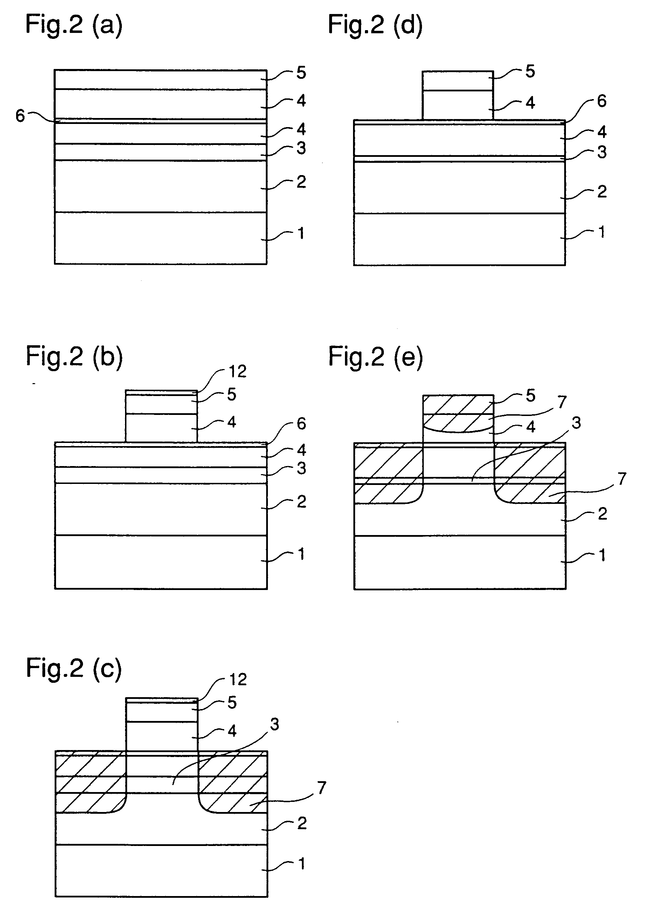

While in the above-illustrated first embodiment, an ion implantation is carried out from the crystal-grown surface, in this first alternative, a method of enhancing the pattern precision is described with reference to figure 2.

As shown in figure 2(a), on an n type GaAs substrate 1, an n type $Al_{0.48}Ga_{0.52}As$ cladding layer 2, a GaAs/AlGaAs MQW active layer 3, a p type $Al_{0.48}Ga_{0.52}As$ cladding layer 4 0.5 µm thick, and a p type $Al_{0.7}Ga_{0.3}As$ etching stopper layer 6 100 Å thick, a p type $Al_{0.48}Ga_{0.52}As$ cladding layer 4 1 µm thick, and a p type GaAs contact layer 5 is successively grown by MOCVD.

After forming a stripe-shaped resist 12 employing photolithography, the p type GaAs contact layer 5 and the p type $Al_{0.48}Ga_{0.52}As$ cladding layer 4 are etched employing ammonium series etchant and tartaric acid etchant up to the etching stopper layer 6 (figure 2(b)).

Next, using the resist 12 as a mask, ion implantation of Zn (or Si, Gu, Al) is carried out to disorder the active layer 3 (figure 2(c)), to form an optical waveguide.

In the fabricating method of the first alternative, because the distance from the surface of a portion to which ion implantation is performed to the active layer 3 is shortened while carrying out the disordering by ion implantation, the accelerating voltage during the ion implantation can be lowered to 700 eV, and further the width of the optical waveguide portion (a portion of the active layer 3 remaining without being disordered) can be controlled to be narrow.

Besides, the processes up to obtaining a structure having a step as shown in figure 2(b) can be made to a process of etching the structure having no p type $Al_{0.70}Ga_{0.30}As$ etching stopper layer as shown in figure 1(b) so as to remain the p type $Al_{0.48}Ga_{0.52}As$ cladding layer 4 by 0.5 µm thick, and thereafter performing ion implantation. In addition, while the etching of the p type GaAs contact layer 5 and the p type $Al_{0.48}Ga_{0.52}As$ cladding layer 4 were carried out by wet etching in the first alternative, these etching can be carried out by dry etching with the same effects.

While in the first alternative, the disordered region 7 is formed by performing ion implantation using the resist 12 as a mask in the structure of figure 2(b), the disordered region 7 can be formed by removing the resist 12 from the state of figure 2(b) to make the state of figure 2(d), and then performing ion implantation to the entire surface as shown in figure 2(e), as a second alternative. Meanwhile, even in the mesa portion comprising the p type GaAs contact layer 5 and the p type $Al_{0.48}Ga_{0.52}As$ cladding layer 4, a disordered region 7 is formed up to a part of the disordered cladding layer 4. However, it does not matter if the disordered region 7 should not reach the active layer 3.

In the fabricating method of an optical waveguide of this first embodiment, the disordered region is formed by performing ion implantation from a state in which the semiconductor layer of the waveguide portion and the semiconductor layer of the cladding portion are in a planar state or a state in which the semiconductor layer of the cladding portion is removed to a predetermined position, whereby, as compared with the prior art burying type or ridge type optical waveguide, the etching process and the burying growth process, or the burying growth process can be eliminated, resulting in having only one crystal growth process, whereby the entire fabricating process is made quite easy, and a high precision optical waveguide can be obtained through such an easy process.

Furthermore, by carrying out ion implantation from a state in which the semiconductor layer of the cladding part is removed up to a predetermined position, the accelerating voltage of ions can be lowered as well as the width of the waveguide portion can be controlled narrow. Further, since there is no concavo-convex at the surface in the burying growth after the etching as in the prior art, a device is formed with a high surface flatness in the above-described planar type one. It is also possible to enhance the photolithography precision of a mask pattern formed on the surface of the device, whereby the processing precision is increased to a large extent.

While in the first embodiment the active layer 3 comprises GaAs/AlGaAs MQW, this can comprise a single quantum well with the same effects described above.

Embodiment 2.

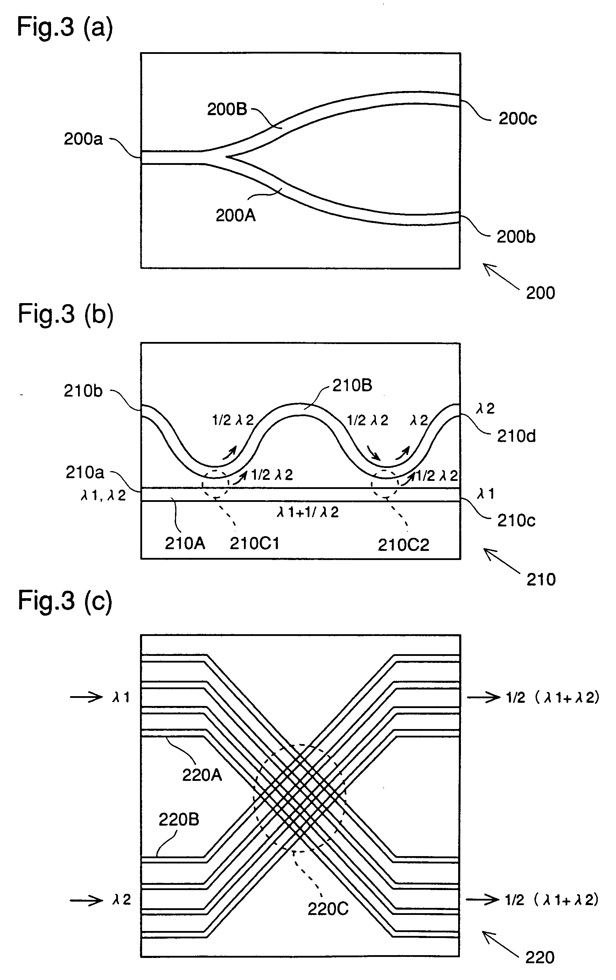

A description is given of a fabricating method of an optical waveguide according to a second embodiment of the present invention with reference to figure 3.

This second embodiment is obtained by applying the method of the first embodiment to formation of optical waveguides such as a Y branch 200, a directional coupler (Mach Chender interferometer) 210, and a cross 220, as shown in figure 3(a), 3(b), and 3(c), respectively.

Constructions and operations of the Y branch 200, the directional coupler 210, and the cross 220, as shown in figure 3(a), 3(b), and 3(c), respectively, will be described as follows.

Figure 3(a) is a diagram illustrating an optical waveguide according to a second embodiment of the present invention. In this example, the optical waveguide portion is the Y branch 200. Reference numeral 200 represents a Y branch comprising waveguide portions 200A and 200B. Reference numeral 200a represents an input portion of the Y branch 200 which receives the output of the semiconductor laser, and reference numerals 200b and 200c represent respective output portions of the Y branch 200. The light input to the input 200a is divided into two and they are output to the outputs 200b and 200c, respectively.

Figure 3(b) is a diagram showing an optical waveguide according to an alternative of a second embodiment of the present invention in which the optical waveguide portion is a directional coupler. The directional coupler 210 includes a first waveguide and a second waveguide 210A and 210B having mutually coupled portions 210C1, 210C2, and this performs an operation that when the output light from the semiconductor laser LD including $\lambda 1$, $\lambda 2$, is input to the left side end 210a of the first waveguide 210A, the light of 1/2 $\lambda 2$ is coupled with the second waveguide 210B at the first coupling portion 210C1, and further the remaining light of 1/2 $\lambda 2$ is coupled with the second waveguide 210B at the second coupling portion 210C2, and $\lambda 1$ is output from the first waveguide 210A, and $\lambda 2$ is output from the second waveguide 210B.

Figure 3(c) is a diagram showing an optical waveguide according to a second alternative of the second embodiment in which the optical waveguide portion is an X cross. The X cross 220 comprises respective four pieces of first and second waveguide 220A, 220B having mutually intersecting portions 220C, and when the output lights respectively including the lights $\lambda 1$, $\lambda 2$ from the respective semiconductor lasers LD are input to the left ends in the figure, of the first and second waveguide 220A, 220B, they are divided into two paths 220A, 220B at the cross part 220C, and respective 1/2 outputs are obtained at respective upper and lower output ends at the right end in the figure, of the X cross 220, and outputs of ($\lambda 1$ + $\lambda 2$) /2 are respectively obtained.

In addition, as another alternative of this second embodiment, it can be also applied to a star coupler (not shown) of a type which introduces light from the LD to a plurality of optical elements through a plurality of waveguides.

The optical waveguide device having respective configurations shown in figure 3 can be fabricated by the same processes described with reference to the first embodiment. Particularly, by carrying out an easy process of ion implantation in the above-described embodiment with a changed mask, it is possible to fabricate waveguides of various configurations, resulting in a simplified process similarly as in the first embodiment.

In the fabricating process of an optical waveguide of this second embodiment, even when fabricating complicated optical waveguides such as the Y branch 200, the directional coupler (Mach Chender type interferometer) 210, and the x cross 220, a method of fabricating a waveguide employing a process of disordering is utilized similarly as in the first embodiment. Therefore, the precision of the manufacture is determined by the precision of photolithography without subjected to the precision by etching, whereby a high precision waveguide can be formed freely and easily.

In the above-described first and second embodiments, a structure and a fabricating method of an optical waveguide utilizing GaAs system material are described, but a structure and a fabricating method of an optical waveguide utilizing InP, AlGaInP system material can be realized similarly as described above, and the same effects as those described above are obtained.

Embodiment 3.

In the above-described first and second embodiments, it has been possible to achieve enhancement of the precision and the controllability at the processing while forming an optical waveguide. In fabricating an optical integrated device which has integrated a semiconductor laser and a waveguide, the method of the above-described embodiment is more effective. This third embodiment of the present invention is obtained by applying the optical waveguide and its fabricating method of the first and the second embodiments to the integrated semiconductor laser and waveguide device in which a semiconductor laser and an optical waveguide are integrated together.

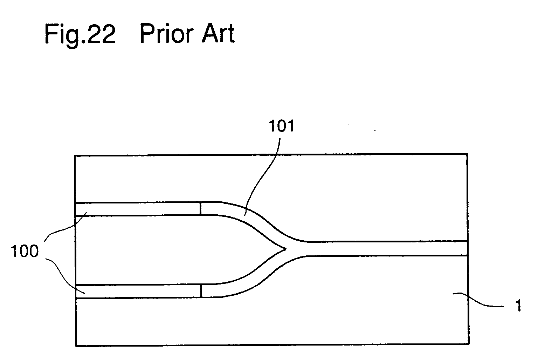

For example, when the semiconductor laser 100 and the wave synthesizer 101 are integrated with each other as shown in figure 22, usually the energy band gap of the wave synthesizer 101 has to be made larger than that of the semiconductor laser 100 by about 50 meV. This has a purpose of preventing that the light emitted from the semiconductor laser 100 receive a large interband absorption at the wave synthesizer 101 and is attenuated to a large amount. As a method for making the energy band gap different, there are two methods of;

(1) performing a growth twice, and
(2) employing a selective growth.

The above-described twice growth method (1) is a method of performing a first growth for growing respective layers of the semiconductor laser 100, then removing a layer that is formed at a portion of the wave synthesizer 101 by the first growth, and thereafter, forming a semiconductor material having a larger energy band gap at a portion of the wave synthesizer 101 again by crystal growth.

The above-described selective growth method (2) is a method of forming a dielectric film before crystal growth partially on a substrate, for example, on a portion thereof for the semiconductor laser 100, and make crystals having energy band gaps different dependent on the laser portion and the wave synthesizer portion grow in the crystal growth.

In the above-described twice growth method (1), however, the process of forming an active layer portion of a laser priorly, removing a portion of the wave synthesizer 101 that is formed by the first growth and that is adjacent thereto, and thereafter, forming a waveguide layer for guiding a light from the active layer at the wave synthesizer portion so as to correspond to the active layer portion of the laser, was quite difficult in its processing, resulting in a problem in the controllability.

In the above-described method (2), the process of adjusting the respective thicknesses of the layers at the semiconductor laser portion and the wave synthesizer portion was difficult in the adjustment and the control of the growth conditions.

In this way, both of these methods have problems in their processing precision and controllability, and a device of sufficient performance can not be obtained.

A fabricating method of an optical waveguide according to a third embodiment of the present invention provides a method of fabricating a semiconductor laser portion and a wave synthesizer portion easily, and an integrated semiconductor laser and waveguide device fabricated by this method.

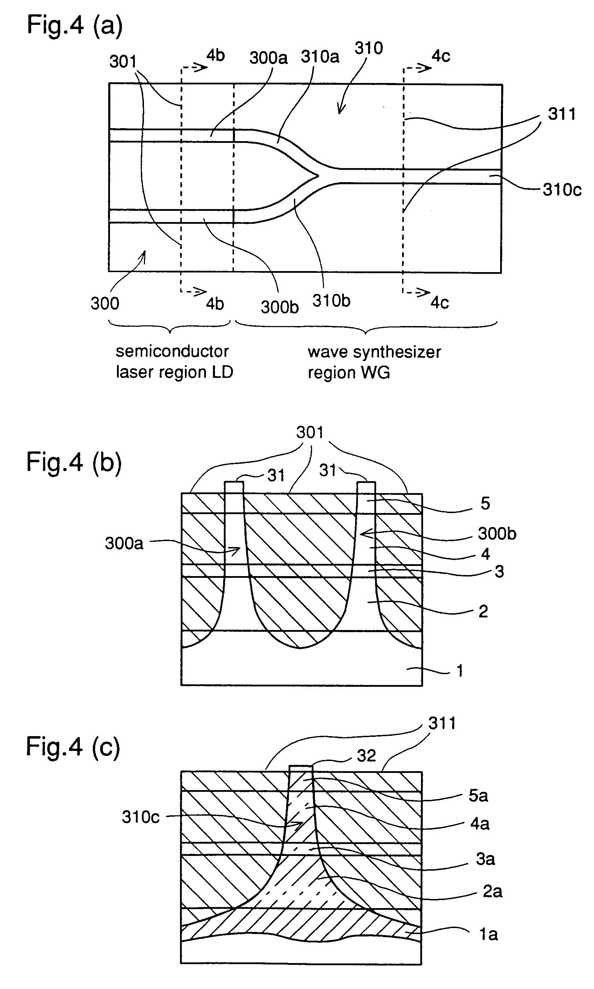

More particularly, the third embodiment of the present invention comprises performing growth of required semiconductor layers 1 to 5 on the entirety of the semiconductor laser 300 and the wave synthesizer 310 similarly as in the first embodiment as shown in figure 4(a), forming masks of the same thicknesses on the portions 300a, 300b, 310a, 310b, and 310c, and performing disordering once by ion implantation to desired regions of the respective semiconductor layers to form disordered regions 301, 311 shown in figures 4(b) and 4(c), and performing disordering of a small amount by ion implantation of small amount as shown by the portions 1a~5a in figure 4(c), to the entirety of only the wave synthesizer 310 portion without using a mask, thereby to form optical waveguides of the semiconductor laser 300 and the save synthesizer 310.

Here, as shown in figures 4(b) and 4(c), by that the thicknesses of the respective masks 31, 32 for forming the semiconductor laser 300 and the wave synthesizer 310 are made different from each other so that the injected ions cannot pass through the thick mask 31 portion and the injected ion can pass through the thin mask 32 portion, the disordering of small amount only at the wave synthesizer 310 portion can be performed. In this case, the ion implantation can be performed by only one time.

In the integrated semiconductor laser and waveguide device of this third embodiment, because the crystal growth can be performed by only once and the device is a planar type, an integrated semiconductor laser and waveguide device with high processing precision and high efficiency is obtained. The energy band gap of the waveguide portion of the wave synthesizer 310 can be made large by an easy process so that interband absorption due to the emitted laser light do not occur at the boundary between the semiconductor laser 300 and the wave synthesizer 310 portion.

In the above-described third embodiment, a combination of the semiconductor laser 300 and the wave synthesizer 310 portion is illustrated, but as alternatives, this can be applied to structures in which semiconductor lasers and the respective kinds of waveguides having configurations as shown in figures 3(a)~3(c) with respect to the second embodiment.

Alternative 1.

An integrated semiconductor laser and waveguide device according to a first alternative of this third embodiment has an optical waveguide portion constituting a Y branch as shown in figure 3(a). The construction of figure 3(a) is same as the construction of the optical waveguide device of figure 3(a).

Alternative 2.

An integrated semiconductor laser and waveguide device according to a second alternative of this third embodiment has an optical waveguide portion constituting a directional coupler as shown in figure 3(b). The construction of figure 3(b) is same as the construction of the optical waveguide device constituting a directional coupler as the first alternative of the second embodiment of the present invention.

Alternative 3.

An integrated semiconductor laser and waveguide device according to a third alternative of this third embodiment has an optical waveguide portion constituting an X cross as shown in figure 3(c). The construction of figure 3(c) is same as the construction of the optical waveguide device constituting an X cross according to the second alternative of the second embodiment of the present invention.

As another alternative of this third embodiment of the present invention, a star coupler of a type guiding light from a semiconductor laser to a plurality of optical elements through a plurality of waveguides can be provided.

The above-described respective alternatives perform the same operations as those described in the second embodiment and its first and second alternatives, and the processes for forming the waveguide of respective alternatives are processes with only a changed in the configuration of the mask during carrying out the ion implantation. The processing precision of respective alternatives is not subjected to the etching precision, and it is determined by the precision of the photolithography technique, resulting in an easy formation of a device of a complicated plane configuration.

In the integrated semiconductor laser and waveguide device of this third embodiment, respective waveguides of a semiconductor laser device and an optical waveguide device formed on the same substrate are formed by disordering due to ion implantation as described with reference to the first and the second embodiments. Waveguide portions of respective waveguide portions are slightly disordered, whereby the energy band gap of the waveguide portion is made larger than that of the waveguide in the semiconductor laser region. Therefore, an integrated semiconductor laser and waveguide device that does not occur light absorption at the junction can be obtained through an easy process as well as a high performance integrated semiconductor laser and waveguide device with enhanced processing precision for a waveguide is obtained.

Embodiment 4.

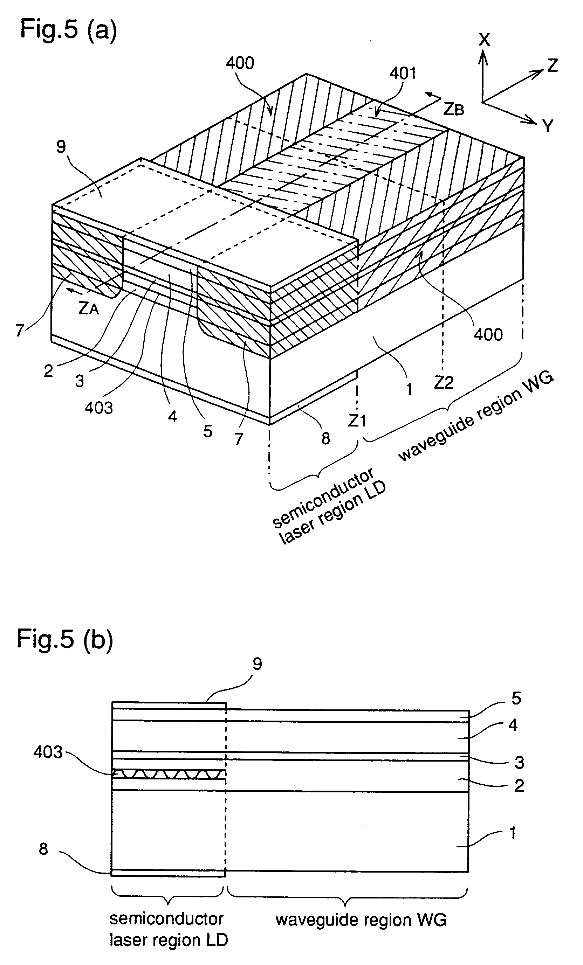

An integrated semiconductor laser and waveguide device according to a fourth embodiment of the present invention will be described with reference to figures 5(a), 5(b).

Figure 5(a) is a diagram illustrating a fourth embodiment of the present invention, and figure 5(b) is a sectional view at a line $Z_A$-$Z_B$ in figure 5(a).

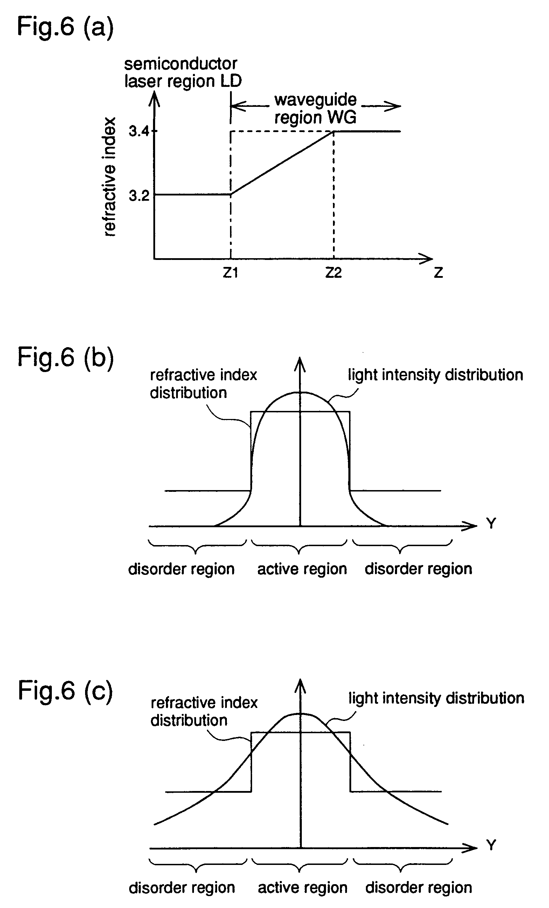

In figures 5(a) and 5(b), reference numeral 400 designates a disordered region in which disordering is performed in the cladding portion of the waveguide region WG so that the refractive index varies in the Z direction (light advancing direction) from the position Z1 to the position Z2 and thereafter it becomes constant. The proportion (amount) of the disordering is different from that in the disordered region 7 of the semiconductor laser region (LD), and it is as shown in figure 6(a). Reference numeral 401 designates a waveguide portion of the waveguide region WG, in which reference numeral 403 designates a distributed feedback grating layer disposed in the lower cladding layer 2, and it is constituted by one having a higher refractive index or a lower refractive index than that of the lower cladding layer 2.

In the semiconductor laser region LD of the integrated semiconductor laser and waveguide device of this fourth embodiment, the distributed feedback grating layer 403 is disposed in the lower cladding layer 2, and the light in the semiconductor laser is reflected by the grating layer 403, thereby to lead to an oscillation. The grating layer 403 may be provided at the side of the upper cladding layer 4.

The length of the semiconductor laser region LD is about 300 μm, the length from Z1 to Z2 of the waveguide region WG is about several 100 μm, and the length from Z2 to the rear end is about 100 μm, and the width of the active layer that is not disordered, of the semiconductor laser region LD is 1 ~ 2 μm, and the height of the semiconductor laser is 100 μm.

Figure 6(a) shows a refractive index of the disordered portion (cladding portion) of the semiconductor laser region LD, and the waveguide region WG, along the Z axis, that is, the light advancing direction. Figure 6(b) shows refractive index distribution and the light intensity distribution in the X-Y cross-section of the semiconductor laser region LD, and figure 6(c) shows refractive index distribution and the light intensity distribution in the X-Y cross-section at the rear end shown in the figure of the waveguide region WG, respectively.

A description is given of the function of the fourth embodiment of the present invention.

When the proportions of the disordered portion 400 of the waveguide region WG and the disordered portion 7 of the semiconductor laser region LD portion are varied to make the waveguide region WG be transparent to the oscillation wavelength of the semiconductor laser and the region 400 is disordered uniformly in the Z axis direction, as shown in figures 6(b) and 6(c), the light intensity distribution do not coincide between the semiconductor laser region LD and the waveguide region WG, whereby reflection of light occurs and large loss would occur. Therefore, in this fourth embodiment as shown in figure 6(a), the refractive index from the junction portion Z1 between the semiconductor laser region LD and the waveguide region WG to the position of Z2 in the way of the waveguide region WG is made a tapered one, which width gradually varies. In this construction, the light intensity distribution is gradually enlarged from the state of figure 6(b) to the state of figure 6(c) in this tapered region TP, whereby loss by such as reflection does not occur.

The width (half value width) of the light intensity distribution of figure 6(b) is about 2 μm, corresponding to the active layer thickness of the semiconductor laser region LD, and the half value width of the light intensity distribution in the waveguide region WG shown in figure 6(c) can be adjusted in accordance with the element, that is connected at a latter stage. In other words, when the output of the integrated semiconductor laser and waveguide device is to be connected to LiNbO$_3$ constituting a modulator, it can be adjusted to be enlarged to about 5 μm, and when it is to be connected to an optical fiber, it can be adjusted to be enlarged to about five times, i.e., to about 10 μm.

In the integrated semiconductor laser and waveguide device of this fourth embodiment, the cladding portion of the semiconductor laser region LD and the cladding portion of the waveguide region are formed by disordering of different ion implantation amounts with the disordering amount of the cladding portion in the semiconductor laser region being larger than that of the cladding portion of the waveguide region. Therefore, the waveguide region having light intensity distribution that is different from that of the semiconductor laser region can be formed with high precision through an easy process with only changed ion implantation amount when forming the waveguide portion.

In addition, by varying the disordering amount of the cladding portion gradually from the semiconductor laser region to the waveguide region, the refractive index distribution and the light intensity distribution in the semiconductor laser region can be varied smoothly to those of in waveguide region, whereby the waveguiding of light from the semiconductor laser to the optical waveguide can be performed without losses due to such as reflection.

Embodiment 5.

A description is given of an integrated semiconductor laser and waveguide device according to a fifth embodiment of the present invention.

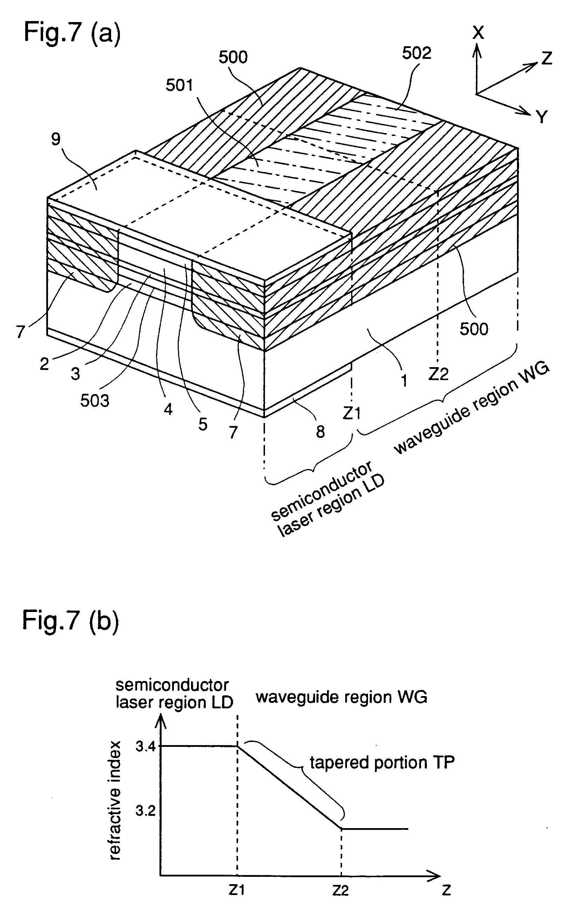

In figure 7(a), reference numeral 500 designates a cladding portion of a waveguide region corresponding to the waveguide region WG of the third embodiment, and this has a proportion of disordering that is equal to that of the cladding region 7 of the semiconductor laser region LD. Reference numeral 501 designates a waveguide portion of the waveguide region WG from the junction point Z1 to Z2, and in this fifth embodiment the amount of disordering is varied in a tapered configuration in the Z direction to vary the refractive index. Reference numeral 502 designates a waveguide portion of the waveguide region WG from the position Z2 of the waveguide region WG to the end thereof. This region is disordered uniformly so as to obtain a constant refractive index.

Figure 7(b) shows a refractive index distribution of the waveguide portion throughout the semiconductor laser region LD and the waveguide region WG. This represents that the tapered portion is gradually disordered so that the refractive index thereof is varied in the Z direction gradually. Thus, the waveguide portion of the semiconductor laser region LD having a larger refractive index and the rear portion of the waveguide portion of the waveguide region WG having a constant refractive index are connected with each other via the tapered portion TP.

A description is given of the function of the fifth embodiment.

As shown in figure 7(a), the disordering amount of the cladding portion 7 of the active layer portion of the semiconductor laser region LD and the disordering amount of the cladding portion 500 of the waveguide region 500 are the same and these can be considered as common cladding portions. On the other hand, in the waveguide portion the disordering quantity is gradually varied from the junction portion Z1 to the junction portion Z2 in the waveguide portion of the semiconductor laser region LD, thereby resulting a refractive index distribution as shown in figure 7(b). Then, the light emitted from the LD is gradually broadened at the tapered portion TP to result coinciding with the light intensity distribution at the rear portion of the waveguide region WG having a constant refractive index, thereby reducing the loss of light due to such as reflection to a minimized value.

In the integrated semiconductor laser and waveguide device according to this fifth embodiment, the disordering amount at the waveguide portion throughout the semiconductor laser region LD and the waveguide region WG is varied in accordance with the advance in the light advancing direction, thereby making the effective energy band gap of the waveguide portion of the waveguide region WG portion gradually increase from the energy band gap of the waveguide portion of the semiconductor laser region LD portion, whereby a waveguide region WG having a small refractive index and is transparent to the oscillation wavelength of the LD is formed.

In addition, assuming that the change of the disordering amount from the semiconductor laser region to the rear end of the waveguide region is a gradual one, the refractive index distribution and light intensity distribution of the semiconductor laser region can be varied smoothly to the refractive index distribution and light intensity distribution of the waveguide region, whereby the waveguiding of light from the semiconductor laser to the optical waveguide can be conducted without occurring loss of light due to such as reflection.

Embodiment 6.

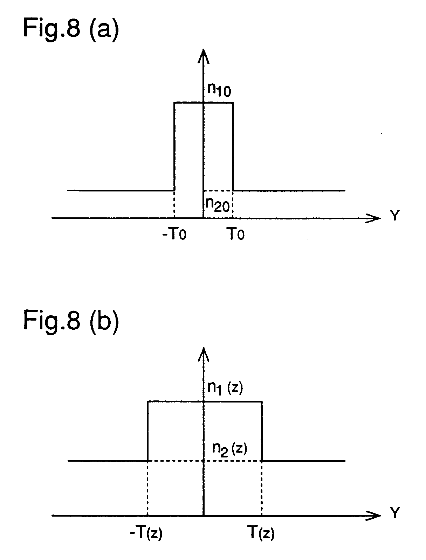

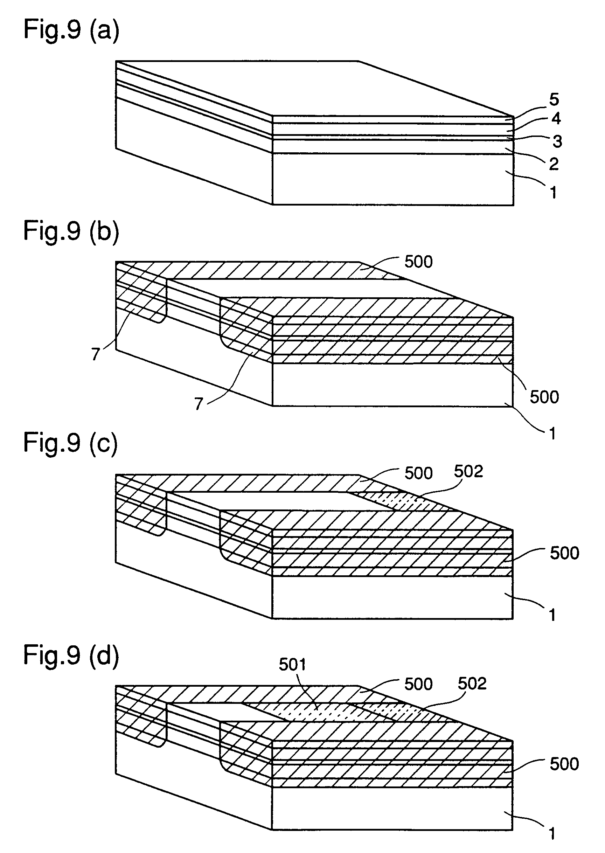

A description is given of an integrated semiconductor laser and waveguide device according to a sixth embodiment of the present invention with reference to figure 8.

Figure 8(a) shows refractive index distribution in the Y direction in the X-Y plane of the semiconductor laser region LD portion of the integrated semiconductor laser and waveguide device according to the fourth embodiment shown in figure 7. In the figure, the refractive index of the waveguide portion is $n_{10}$ and the refractive index of the cladding portion is $n_{20}$. The width of the waveguide portion is $2T_0$.

Figure 8(b) shows refractive index distribution in the Y direction in the X-Y plane of the tapered portion TP of the waveguide region WG of the integrated semiconductor laser and waveguide device according to the sixth embodiment of the present invention. The refractive index of the waveguide portion, the refractive index of the cladding portion, and the width of the waveguide portion are respectively n1(z), n2(z), and 2T(z), all being functions of the position Z in the advancing direction in this sixth embodiment. In addition, the semiconductor laser region LD in this sixth embodiment is the same as that in the fourth embodiment.

The normalized frequency $V_0$ of the semiconductor laser region LD can be defined in the following formula:

$$V_0 = (2\pi/\lambda) \cdot \sqrt{n_{10}^2 - n_{20}^2} \cdot T_0$$

In the above formula, $\lambda$ is an oscillation wavelength of a semiconductor laser. On the other hand, the normalized frequency V(z) of the tapered region TP is represented as follows:

$$V(z) = (2\pi/\lambda) \cdot \sqrt{n_1(z)^2 - n_2(z)^2} \cdot T(Z)$$

The n1(Z), n2(Z), and 2T(Z) are varied so that the normalized frequency V(Z) at the tapered region TP is equal to the normalized frequency $V_0$ of the semiconductor laser region LD, that is,

$$V(Z) = V_0.$$

In order to adjust the region to be disordered having perfectly a constant disordered quantity, the implantation is carried out with the dose quantity of a predetermined, for example, N pieces, and for example, when annealing is carried out at a temperature of 800 °C for four hours, the disordering is carried out perfectly flat. In this case, the normalized frequency and the dose quantity correspond to each other one by one perfectly. On the other hand, when N pieces of dose quantity are injected and annealing is performed with an inclined temperature of 800 ~ 600 °C, different dependent on positions for four hours, gradual disordering is carried out because the complete disordering is carried out at 800 °C and the complete disordering is not carried out at 600 °C.

In this way, by making the number of modes allowed at the tapered region TP coincide with the mode number of the semiconductor laser region, in other words, by making the tapered region so as to have a mode number of 1 because the mode number of the usual semiconductor laser region has a mode number of 1 with considering the above-formula, the mode conversion (transformation of light intensity distribution) can be carried out smoothly, and the loss of light due to reflection at the interface can be reduced.

In this sixth embodiment, the mode number allowed at the tapered region of the waveguide region is coincided with the mode number allowed at the semiconductor laser region LD, and the mode conversion (transformation of the light intensity distribution) can be carried out smoothly, and the loss of light at the transition from the semiconductor laser to the optical waveguide can be made small.

Embodiment 7.

A description is given of a fabricating method of an integrated semiconductor laser and waveguide device according to a seventh embodiment of the present invention with reference to figure 9 and figure 7.

As shown in figure 9(a), a lower cladding layer 2, a quantum well active layer 3, an upper cladding layer 4, and a contact layer 5 are sequentially epitaxially grown.

Next, as shown in figure 9(b), for example, dopants such as Si are injected into portions of the semiconductor laser region LD and the waveguide region WG which portions are to be cladding regions. The dose quantity then is made $M_0 (= 1 \times 10^{20} cm^{-3})$. The region to which ion implantation is not to be carried out is masked by a metal film, an insulating film, and the like.

In figure 9(c), in order to form a waveguide part 502 at the rear end of the waveguiding region WG, where the disordering quantity should be constant, ion implantation is carried out with a constant dose quantity of $M1 = 1 \times 10^{19} cm^{-3}$.

Next, in figure 9(d), ion implantation is carried out into the waveguide part 501 of the waveguide region WG in which the disordering quantity of which part is to be tapered, so that the disordering quantity of that region should be tapered. In order to make the disordering quantity a tapered one, the ion implantation is carried out with dose quantity of three values for respective regions which are divided into three along the Z direction from the side of the semiconductor laser region LD to the side of the waveguide region WG. The average dose quantity then is M2(Z). There is the following relation between the dose quantity M0, M1, and M2(Z):

$$M0 > M1 \geq M2(Z)$$

This device to which the ion implantation is carried out is annealed, for example, at 800 °C for three hours, and thereafter, an electrode 9 and an electrode 8 (figure 7(a)) are produced at above and below the semiconductor laser region LD, thereby completing an integrated semiconductor laser and waveguide integrating device.

In order to adjust so that the region to be disordered have completely constant disordering quantity, it is sufficient to carry out the implantation with the dose quantity of N pieces, as a prescribed value at a temperature of 800 °C for four hours, thereby achieving implantation with completely flat disordering. Meanwhile, it is possible to achieve implantation with gradual disordering by carrying out the implantation with the dose quantity of N pieces at an inclined temperature of 800°C to 600°C dependent on positions, for four hours, because complete disordering is realized not at 600°C but at 800 °C.

A description is given of the function of the seventh embodiment of the present invention.

The semiconductor laser region and the waveguide region are formed on a same substrate by once growth process, and respective cladding parts and waveguide parts are formed by disordering due to ion implantation so that there arises no generation of notches due to etching and regrowth, thereby a device of high precision can be realized by an easy process. In addition, it is possible to form a portion where the refractive index varies in a tapered configuration by an easier process without employing etching and regrowth processes by carrying out disordering with varying the dose quantity stepwisely for the respective divided regions for which the disordering quantity should be varied gradually. While in this seventh embodiment the integrated semiconductor laser and waveguide device is described as having the waveguide part which is gradually disordered as in the fifth embodiment, it is also possible to carry out disordering stepwisely with changing the dose quantity for respective desired portions in a device in which the cladding part is gradually disordered as in the fourth embodiment, thereby resulting regions having refractive indices which varies in a tapered configuration.

Also in the sixth embodiment, the refractive indices n1(Z), n2(Z), and 2T(Z) can be adjusted by varying the dose quantity and the mask configuration when carrying out the disordering.

In the integrated semiconductor laser and waveguide device of the seventh embodiment, the disordering quantity of the waveguide part over the semiconductor laser region LD and the waveguide region WG are varied in a tapered configuration in accordance with the advanced position in the light traveling direction, thereby the integrated semiconductor laser and waveguide device can be fabricated quite easily without etching process and with high processing precision. In addition, the integrated semiconductor laser and waveguide device of the fourth embodiment and the sixth embodiment can be fabricated through the similar process.

## Embodiment 8.

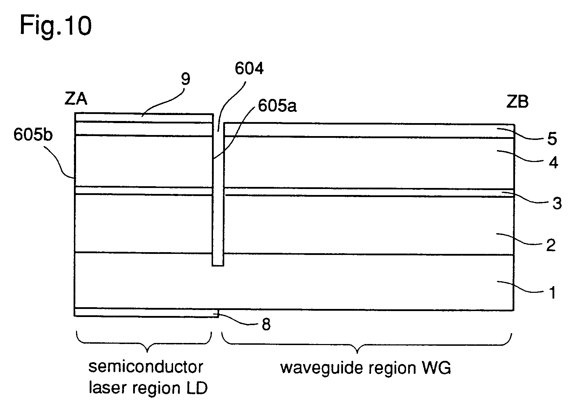

A description is given of an integrated semiconductor laser and waveguide device according to an eighth embodiment of the present invention with reference to figure 10.

Figure 10 is a sectional view in X-Z plane of the core region of the integrated semiconductor laser and waveguide device according to an eighth embodiment of the present invention. In the figure, reference numeral 604 designates a groove formed by a dry etching employing chlorine series gas, and the width thereof is several μm to several tens μm. The internal surface 605a of the groove 604 at the side of the semiconductor laser is formed vertically and reference numeral 605b designates a facet of a semiconductor laser formed by the usual fabricating process.

A description is given of the function of the eighth embodiment of the present invention.

Since the facet 605a of the semiconductor laser region LD is formed vertically by the groove 604, this serves as a facet of a semiconductor laser, and it is possible to form a resonator with the facet 605b which is a resonator facet at the side confronting to that facet. It is possible to obtain about 30 % as reflectivity of the resonator facet.

In the integrated semiconductor laser and waveguide device of this eighth embodiment, it is possible to have resonator facets 605a and 605b with the groove 604, and it is possible to obtain an integrated semiconductor and waveguide device that has a resonance function in the semiconductor laser region, without providing distributed feedback type grating layers 403, 503, 803, and 903 shown in figures 5 and 7, and later embodiments.

The surface of the groove 604 at the side confronting to the resonator facet 605a may be an inclined surface that has an aperture of the groove becoming larger with advancing upwards. This structure enables to reduce multiple reflections that would occur when a vertical groove is provided.

## Embodiment 9.

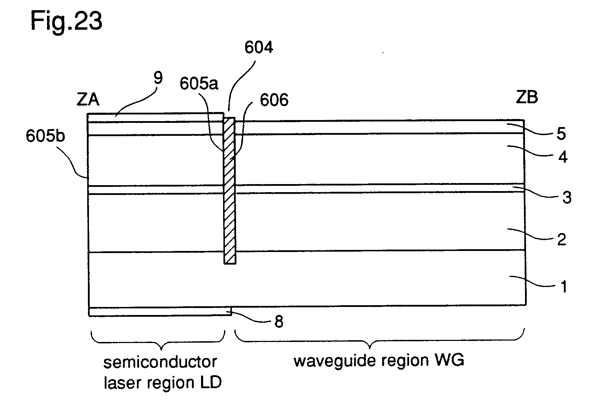

A description is given of an integrated semiconductor laser and waveguide device according to a ninth embodiment of the present invention with reference to figure 23.

Figure 23 shows a sectional view in the X-Z direction of the core region of the integrated semiconductor laser and waveguide device according to the ninth embodiment of the present invention. In the figure, reference numerals 604, 605a, and 605b designate those the same as in figure 10(a). Reference numeral 606 designates a relaxation film formed burying the groove 604, and the refractive index of the film 606 is larger than that of air, i.e., 1, and smaller than about 3.4, which is the effective refractive index of the LD. As concrete material therefor, it is possible to use $SiO_2$ (refractive index : 1.45) and $Al_2O_3$ (refractive index : 1.6).

When a material having a desired refractive index is used for the relaxation film 606, the relaxation film 606 can arbitrarily adjust the reflectivity of the laser emitting facet as well as protect the facet of the semiconductor laser facet. For example, it is possible to lower the reflectivity of the facet that is about 30 % in the eighth embodiment to about 10 %. To the contrary, when the gain of the semiconductor laser is small, it is possible to raise the reflectivity to about 50 %.

In this way, in the integrated semiconductor laser and waveguide device of this ninth embodiment, it is possible to protect the facet 605a of the semiconductor laser by filling the relaxation film 606 in the groove 604 that is provided in the eighth embodiment, and it is also possible to adjust the reflectivity of the facet of the semiconductor laser in accordance with the characteristics of the semiconductor laser by selecting a material having a desired value for the refractive index of the relaxation film 606.

## Embodiment 10.

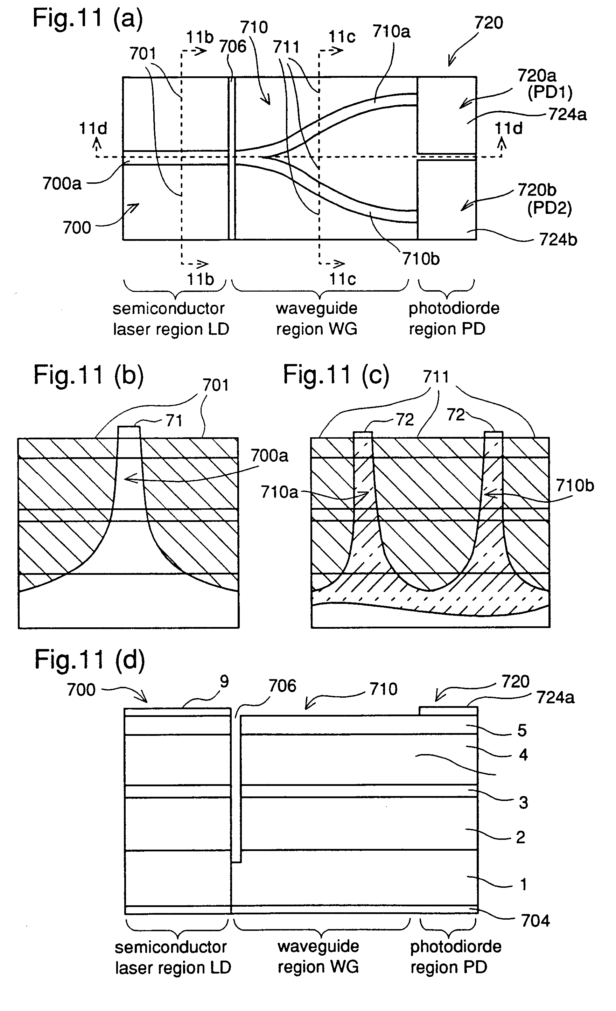

Figure 11 shows an integrated semiconductor laser - waveguide - photodiode device according to a tenth embodiment of the present invention. The device has a semiconductor laser region (LD), an optical waveguide region (WG), and a photodiode region (PD), and these are disposed on a same substrate. More particularly, the integrated semiconductor laser - waveguide - photodiode device comprises the semiconductor laser region 700, the optical waveguide region 710, and the monitoring photodiode region 720 on the same substrate. It has a waveguide region 710 which divides the output light emitted to the right from the semiconductor laser 700 into two as shown in figure 11(a), and it has photodiode regions 720 at the right of the respective outputs of the divided-into-two outputs. Figure 11(b) shows a cross-section in broken line 11b of figure 11(a), figure 11(c) shows a cross-section in broken line 11c of figure 11(a), and figure 11(d) shows a cross-section in broken line 11d of figure 11(a). The photodiode region 720 is formed by the same crystal growth similar as the respective layers of the semiconductor laser 700, and the optical waveguide 710. When a reverse bias is applied to the pn junction included in the layers 2 ~ 4 from the electrode 704 and the electrode 724a, and from the electrode 704 and the electrode 724b, the photodiode region 720 is operated as a photodiode, whereby an integrated semiconductor laser - waveguide - photodiode is constructed. Here, reference numeral 9 designates a p side electrode disposed at the side of the semiconductor laser region, numeral 704 designates an n side electrode disposed commonly through the semiconductor laser region LD 700, the waveguide region WG 710, and the photodiode region PD 720, and numeral 706 designates a groove provided between the semiconductor laser region LD 700 and the waveguide region WG 710.

A description is given of the fabricating method of this embodiment.

First of all, on an n type GaAs substrate 1, an n type $Al_{0.5}Ga_{0.5}As$ cladding layer 2 to which Se is doped to a carrier concentration of $1 \times 10^{18}cm^{-3}$, a multi-quantum well layer 3 comprising an $Al_{0.2}Ga_{0.8}As$ layer of 300 Å thickness, a GaAs layer of 80 Å thickness, and an $Al_{0.2}Ga_{0.8}As$ layer of 100 Å thickness, a GaAs layer of 80 Å thickness, and an $Al_{0.2}Ga_{0.8}As$ layer of 300 Å thickness, and a p $Al_{0.5}Ga_{0.5}As$ layer4 to which Zn are doped to a concentration of $1 \times 10^{18}cm^{-3}$, and a p GaAs layer 5 to which Zn are doped to a concentration of $5 \times 10^{18}cm^{-3}$ are successively grown.

Next, a silicon dioxide film is formed at a portion other than the waveguide region WG and employing this silicon diode film as a mask, Si is injected into a region reaching the substrate to a concentration of $1 \times 10^{18}cm^{-3}$. Thereby, the ion injected regions shown by one point chain line by 710a, 710b of figure 11(c) are formed.

After the removal of the $SiO_2$ film, an $SiO_2$ film serving as masks 71 and 72 is formed again on the region of the optical waveguide in the integrated semiconductor laser region LD and the waveguide region WG. In addition, the $SiO_2$ mask is also provided on the photodiode region PD. Si is implanted to a concentration of $3 \times 10^{18}$ $cm^{-3}$ up to reaching the substrate using these $SiO_2$ masks. Thereby, the ion implanted regions shown by hatched lines as 701 and 711 in figure 11(b) and 11(c) are formed.

Then, when the substrate thus formed is heated at 850°C for thirty minutes, the ion implanted region is disordered to an amount of its concentration and waveguide portions shown by 700a, 710a, and 710b of figure 11 are formed. Next, in order to form a resonator in the semiconductor laser region, the groove 706 is formed by dry etching as in the eighth embodiment, and finally, the electrodes 9, 704, 724a, and 724b are formed.

In addition, the ion implanted regions of the semiconductor laser region LD and the waveguide region WG can be formed as shown in the third to sixth embodiments, and the waveguide can be of various configurations without changing the configuration of the mask when performing the ion implantation.

A description is given of the function of the integrated semiconductor laser - waveguide - photodiode device according to the tenth embodiment.

In the integrated semiconductor laser - waveguide - photodiode device of this tenth embodiment, it is possible to achieve a laser light receiving efficiency of about 100 % by providing monitor photodiodes 720a and 720b having a large light receiving area against the outputs from the optical waveguides 710a and 710b. On the other hand, when a photodiode having a large light receiving area is formed by the conventional etching method, abnormal growth occurs at the crystal growth after the etching, and the width of the light receiving part of the photodiode is restricted to have a width of about 3μm and the light receiving efficiency is restricted to a value of 70 ~ 80 %. On the contrary, in this embodiment, since there arises no abnormal growth at the crystal growth as described above, the light receiving efficiency of the photodiode region that is determined in accordance with the light receiving area can be made a larger value. This makes it possible to obtain quite a large value with relative to the prior art even when the entire surface is not used for the light receiving width, and a light receiving efficiency of about 100 % is easily obtained.

In addition, in this tenth embodiment, the semiconductor laser region LD, and the waveguide region WG may have gradually varying disordering quantity as described in the seventh embodiment, and these devices can have similar effects as in the above-described respective embodiments.

It will be easily appreciated if the tenth embodiment will be applied, the device integrating only the semiconductor laser region (LD) and the photodiode region (PD) can be easily fabricated.

In the fabricating method of an integrated semiconductor laser - waveguide - photodiode device and the integrated semiconductor laser - waveguide - photodiode device fabricated according to this tenth embodiment, the semiconductor laser region, the waveguide region, and the photodiode region are formed by one time growth process on a same substrate, and the cladding portions and waveguide portions of respective regions are formed by disordering due to ion implantation. Therefore, there arise no generation of notches due to the etching and the regrowth, and a device can be formed at high precision with easier process. In addition, the light receiving efficiency of the photodiode can be made approximately 100 % by the enhancement of the formation precision.

Embodiment 11.

A description is given of an integrated semiconductor laser - waveguide - mode matching circuit device according to an eleventh embodiment of the present invention.

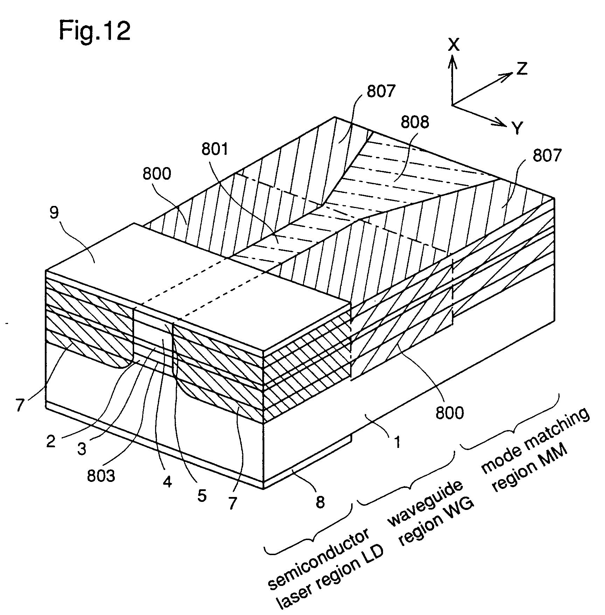

Figure 12 shows an integrated semiconductor laser - waveguide - mode matching circuit according to an eleventh embodiment of the present invention. This device has the semiconductor laser region LD, waveguide region WG, and the mode matching circuit region MM on a same substrate. In the figure, reference numeral 800 designates a cladding portion of the waveguide region WG, numeral 801 designates a waveguide portion of the waveguide region, numeral 807 designates a cladding portion of the mode matching circuit region MM, and numeral 808 designates a waveguide portion of the mode matching region MM. The other reference numerals designate the same or corresponding portions as described with reference to other drawings.

Generally, the refractive indices of optical elements such as an optical fiber and $LiNbO_3$ are smaller than those of the semiconductor lasers, and when the semiconductor laser and the optical elements such as an optical fiber and LiNbO$_3$ are directly connected, the modes of the both do not match with each other, thereby occurring optical loss. Therefore, this eleventh embodiment provides the mode matching region MM for matching the modes of the optical element and the semiconductor laser which are to be connected with each other and the semiconductor laser on the same substrate.

In addition, the broadening of the light intensity distribution of the optical element such as an optical fiber and LiNbO$_3$ is larger than that of the semiconductor laser which has a large refractive index and therefore, the configuration of the rear portion of the mode matching region MM is formed broadened in a tapered configuration. Then, the configuration of this tapering is broadened in an angle of several degrees and it is not made a larger angle so that it is not converted into other higher mode at the tapered portion 808 of the mode matching region MM.

In addition, the waveguide part and the cladding part of the mode matching region MM are formed by disordering the quantum well active layer, and the disordering quantity of the waveguide part 808 of the mode matching region MM is made the disordering quantity that is equal to that of the waveguide part 801 of the waveguide region WG, or larger than the above-described disordering quantity so that the energy band gap thereof is broadened and it transparent to the light. Similarly, the disordering quantity of the cladding portion of the mode matching region MM is made the same as or lower than that of the cladding portion 800 of the waveguide region WG so that the broadening of light in this region do not occur.

In the integrated semiconductor laser - waveguide - mode matching circuit device according to the eleventh embodiment, in order to connect the semiconductor laser or its waveguide with an optical element such as an optical fiber or LiNbO$_3$ having a small refractive index with relative to the former, the mode matching region portion MM is integrated with the semiconductor laser and the optical waveguide, and the waveguide part 808 is made of a tapered configuration as it comes to the rear end, therefore, the fundamental mode which propagates the waveguide region WG is not converted into the other higher mode as the tapered portion 808, whereby an integrated semiconductor laser - waveguide - mode matching device having less loss of light due to such as reflection in the connection thereof with such as the optical fiber is obtained.

Embodiment 12.

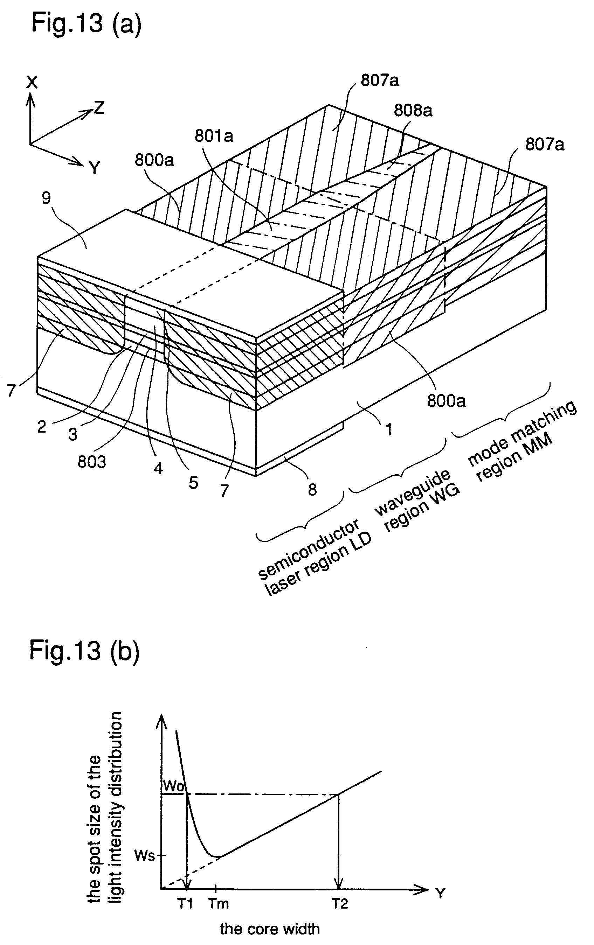

A description is given of an integrated semiconductor laser - waveguide - mode matching circuit device according to a twelfth embodiment of the present invention with respect to figures 13(a) and 13(b).

In figure 13(a), reference numeral 807a designates a cladding part of the mode matching region and numeral 808a designates a waveguide part of the mode matching region. As shown in the figure, in this twelfth embodiment, the waveguide part 808a of the mode matching region MM is of a tapered waveguide which is narrowed with advancing in the light traveling direction.

There is a relation as shown in figure 13(b) between the width (T) of the waveguide part and the spot size (W) of the light intensity distribution. More particularly, it becomes the minimum size at some width (Tm) of the waveguide part and even when the width become smaller than that to be T1, or larger than that to be T2, the spot size becomes broadened.

In this twelfth embodiment, the core width T is narrowed to widen the spot size W, so as to perform matching of the mode with the optical element such as an optical fiber and LiNbO$_3$. Here, the eleventh embodiment of figure 12 is one which widens the width of the core so as to broaden the spot size.

Thereby, in the integrated semiconductor laser - waveguide - mode matching circuit device of this twelfth embodiment, the same effect as in the eleventh embodiment is obtained in the integrated semiconductor laser - waveguide - mode matching circuit having a mode matching region having a different configuration from that of the eleventh embodiment.

Embodiment 13.

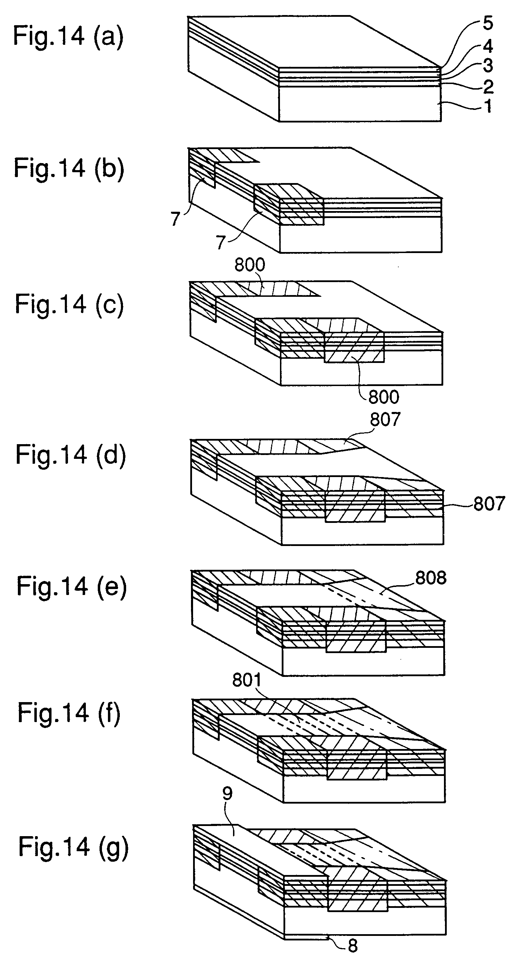

A description is given of an integrated semiconductor laser - waveguide - mode matching circuit device according to a thirteenth embodiment of the present invention with reference to figures 14(a)-14(g).

In the figures, the same reference numerals as in figure 12 and figures 13(a)-13(b) designate the same or corresponding elements.

A description is given of the fabricating method.

As shown in figure 14(a), a lower cladding layer 2, a quantum well active layer 3, an upper cladding layer 4, and a contact layer 5 are successively epitaxially grown on the substrate 1.

Next, in figure 14(b), a mask is provided on the substrate having openings at portions 7 which serve as cladding parts of the semiconductor laser region LD, and dopants such as Si are ion implanted employing the mask to perform disordering. The disordering quantity then is made larger than any of the disordering quantity in the process performed thereafter. Next, as shown in figure 14(c), a mask is provided on the substrate having openings at parts 800 becoming cladding parts of the waveguide region WG, and the disordering by ion implantation is carried out similarly as above. The disordering quantity then is made either equal to or less than the disordering quantity of the cladding parts 7 of the semiconductor laser region. Further, as shown in figure 14(d), a mask is provided having openings at the parts 807 which become cladding parts of the mode matching region, and the disordering by the ion implantation is carried out similarly as above. The disordering quantity then is made equal to or less than the disordering quantity of the cladding part 800 of the waveguide region. Further, while the configuration of the mask employed here has a tapered configuration in which its rear part is broadened as in the eleventh embodiment, it may a configuration in which the rear part may be a tapered configuration which is narrowed in its rear part as in the twelfth embodiment.

Next, as shown in figure 14(e), a mask having an opening at the waveguide part 808 of the mode matching region MM is provided, and disordering is performed by the ion implantation. The disordering quantity then is made to less than that of the cladding part 807. As shown in figure 14(f), a mask having an opening at the waveguide part 801 of the waveguide region WG is provided and the disordering due to ion implantation is performed. The disordering quantity then is made either equal to or less than that of the waveguide part 808 of the mode matching region. Finally, the device to which ion implantation is performed is annealed, for example, at 800 °C for three hours, and thereafter, as shown in figure 14(g), electrodes 8 and 9 are formed at the upper and lower surfaces of the semiconductor laser region, thereby forming an integrated semiconductor laser - waveguide - mode matching device is obtained.

In the fabricating process of this embodiment, the ion implantation is carried out divided into five times, but by dividing the thickness of a mask shielding the ions into several stages, it is possible to vary the ion implantation amount. In this case, it is possible to reduce the times of the ion implantation.

The respective portions formed by the respective processes of the five ion implantation processes can be formed so that the refractive index distribution of the cladding part and the waveguide part vary in tapered configurations in the Z axis direction by performing ion implantation for the regions obtained by further dividing the respective regions into a plurality of regions, and they may be constructed in a similar way as those shown in the third to sixth embodiments.

In this embodiment, in the above-described fabricating process, by varying the refractive index n1(Z) of the cladding part of the mode matching region MM, the refractive index n2(Z) of the waveguide part, and the width T(Z) of the waveguide part, the normalized frequencies of the waveguide region WG and the mode matching region MM can be adjusted to coincide with each other. In other words, when the width of the waveguide part is widened, the refractive index difference between the waveguide part and the cladding part is made small, i.e., not to be so large, and similarly as shown in the sixth embodiment, the normalized frequencies are adjusted to always coincide with each other, thus the device is fabricated.

A description is given of the function of the thirteenth embodiment.

In this thirteenth embodiment, since the waveguide part and the cladding part forming the waveguide of the integrated semiconductor laser - waveguide - mode matching device are produced by varying the disordering quantity of respective portions, the crystal growth of the semiconductor layer is enough to be once, the crystal growth process for forming the cladding part is unnecessitated, and the integrated semiconductor laser - waveguide - mode matching circuit can be fabricated by an easy process. In addition, since the normalized frequencies of the waveguide region and the mode matching region are made coincided each other, the mode conversion can be performed smoothly without generating multi modes.

In the fabricating method of the integrated semiconductor laser - waveguide - mode matching circuit device of this thirteenth embodiment, the method comprises the process of growing respective crystals of the above-described semiconductor, the process of disordering the cladding portion of the grown semiconductor layer, the process of disordering a desired portion of the waveguide part, and the process of forming electrodes on the semiconductor laser region. Therefore, the crystalline growth process for forming the cladding portion can be dispensed with and the process is simplified. Since the formation of the cladding part is carried out by disordering due to ion implantation, there arises no concavo-convex of the surface after the burying growth due to etching, whereby no notches are produced at the surfaces, and the photolithography precision of the mask pattern formed on the surface is largely enhanced, thereby the processing precision can be largely enhanced. Since the normalized frequencies of the waveguide region and the mode matching region are coincided with each other, it is possible to convert the mode conversion without generating multi-modes, and the loss of light at the transition from the semiconductor laser to the optical waveguide can be made small.

In the first to the thirteenth embodiments, the disordering quantity is controlled by varying the dose quantity at the ion implantation, but the disordering quantity can be controlled by diffusion of such as Zn, and the same effects can be obtained.

Embodiment 14.

A description is given of the mode matching element according to a fourteenth embodiment of the present invention.

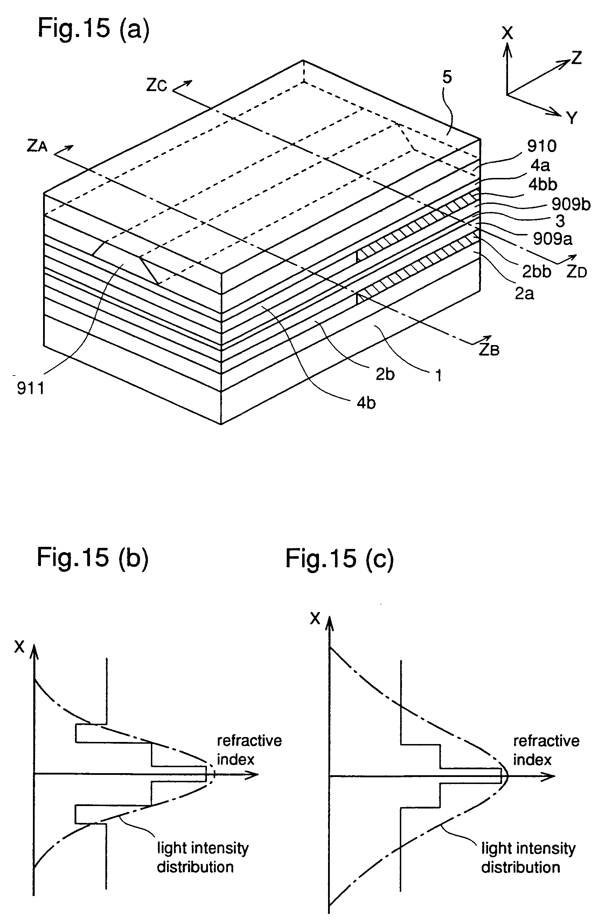

Figure 15(a) shows a mode matching element according to a fourteenth embodiment of the present invention. Reference numeral 1 designates a substrate, numeral 2a designates a first lower cladding layer, numeral 2b designates a second lower cladding layer, numeral 2bb designates a disordered second lower cladding layer, numerals 909a, 909b designate light guide layers, numeral 3 designates a quantum well active layer, numeral 4a designates a first upper cladding layer, numeral 4b designates a second upper cladding layer, and numeral 911 designates a cap layer provided on the center of the first upper cladding layer 4a and comprising a material having a larger refractive index than that of the first upper cladding layer 4a. Reference numeral 910 designates a blocking layer provided at both sides on the first upper cladding layer 4a putting between the cap layer 911 and comprising a material having a smaller refractive index than that of the first upper cladding layer 4a. Here, the second lower cladding layer 2b and the second upper cladding layer 4b comprises a material having a smaller refractive index than that of the first lower cladding layer 2a and the first upper cladding layer 4a, respectively. Reference numeral 5 designates a GaAs contact layer covering the layer including Al so as not to make it exposed.

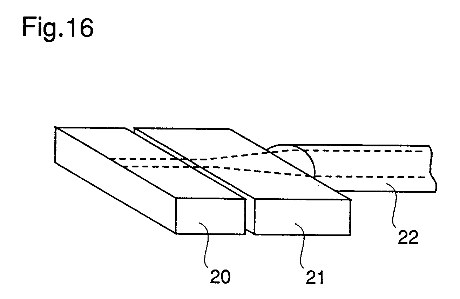

Figure 15(b) represents the refractive index distribution and light intensity distribution in the X direction in the X-Y plane in line $Z_A$-$Z_B$ in figure 15(a), and figure 15(c) represents the refractive index distribution and the light intensity distribution in the X direction in the X-Y plane in line $Z_C$-$Z_D$ in figure 15(a), respectively. Figure 16 shows a schematic diagram showing the use state of the mode matching element, in which reference numeral 20 designates a semiconductor laser, numeral 21 designates a mode matching circuit device, and numeral 22 designates an optical fiber.

A description is given of a function of this embodiment of the present invention.

In this mode matching element, the light is guided along the cap layer having a lower refractive index than that of the blocking layer 910. When the second lower cladding layer 2b and the second upper cladding layer 4b are not disordered, the light is confined in the quantum well active layer 3 and the light guide layers 909a, 909b, thereby presenting the light distribution as shown in figure 15(b). On the other hand, in the layers (4bb, 2bb) in which the second upper cladding layer 4b and the second lower cladding layer 2b are disordered, the refractive index changes as shown in figure 15(c), resulting in broadening the light intensity distribution. This results in that the second upper and lower cladding layers 4b, 2b which are sufficiently thin relative to the first upper and lower cladding layers 4a, 2a are disordered and Al atoms included in respective layer are mixture crystallized, resulting in lowering the refractive indices of the disordered second upper and lower cladding layers 4b, 2bb. By using this method, it is also possible to broaden the light intensity distribution also in the epitaxial growth direction (X axis direction), and by making it the same as that in the Y axis direction, it is possible to make the light intensity distribution close to a circular one.

In the mode matching element according to this fourteenth embodiment, a mode matching region is provided in a waveguide region as a single element, and by that disordered second lower cladding layer 2bb and second upper cladding layer 4bb are provided in the mode matching region, it is possible to construct a mode matching element by a single element. In addition, it is possible to broaden the light intensity distribution also in the epitaxial growth direction (X axis direction) to form the light intensity distribution closer to a circular configuration. Therefore, it is possible to perform a mode matching with the light intensity distribution having a configuration closer to a circular configuration as a single element.

Embodiment 15.

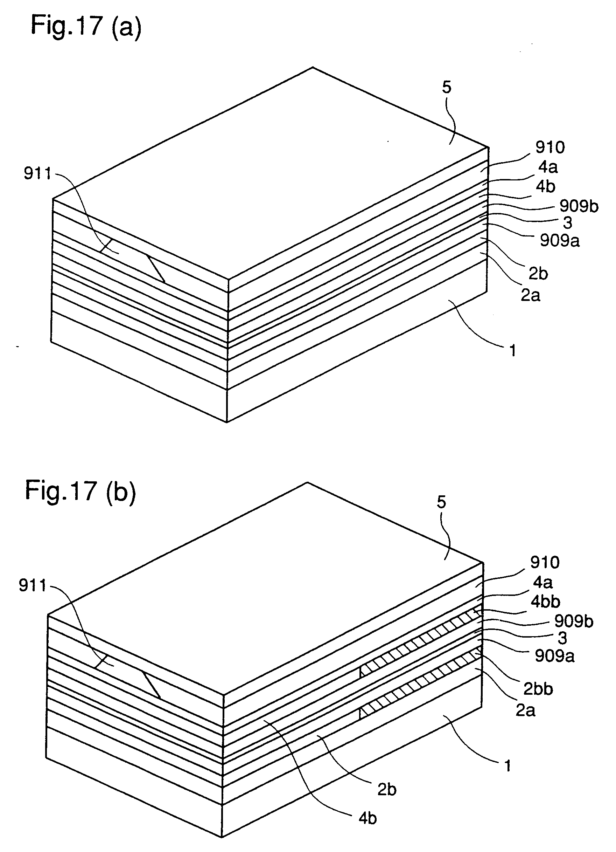

A description is given of a fabricating method of a mode matching element according to a fifteenth embodiment of the present invention with reference to figures 17(a) and 17(b).

First of all, respective layers shown in figure 17(a) are obtained by three time crystal growth. More particularly, on the substrate 1, the first lower cladding layer 2a, the second lower cladding layer 2b, the light guide layer 909a, the quantum well active layer 3, the light guide layer 909b, the second upper cladding layer 4b, the first upper cladding layer 4a, and the cap layer 911 comprising a material having a larger refractive index than the first upper cladding layer 4a are grown, a mask is provided at a portion which is to be a waveguide of the cap layer 911, a blocking layer 910 is selectively grown on the etched portion, and the mask is removed and the contact layer 5 is grown, thereby obtaining a structure shown in figure 17(a).

Thereafter, a mask is provided at a desired region at the side of the semiconductor laser, and the ion implantation is performed twice so that the ions reach the second lower cladding layer 2b and the second upper cladding layer 4b, respectively, with setting the kinds of implanted ions and the values of the ion implantation energy at the ion implantation. The ion implantation is thus performed only to the portions of the second lower cladding layer 2bb and the second upper cladding layer 4bb, and thereafter, the disordering is performed by diffusing the implanted ions by performing annealing, for example, at 800°C and for three hours, to form the disordered second lower cladding layer 2bb and disordered second upper cladding layers 4bb.

A description is given of the function of this embodiment.

In this embodiment, the second lower cladding layer 2b and the second upper cladding layer 4b which are sufficiently thinner than the first lower cladding layer 2a and the first upper cladding layer 4a are formed, and the refractive index is varied by the process performing the disordering employing the ion implantation. By this process, a mode matching element that can broaden the light intensity distribution also in the X axis direction can be obtained. In addition, since the refractive index is varied by performing the disordering after growing the respective semiconductor layers, no new growth process and etching process are required for forming the layers having different refractive indices. Here, the configuration of the mask and the ion implantation energy while performing the disordering can be arbitrarily set, and only desired layers can be changed to have different refractive indices by an easier process. In addition, in this embodiment only the example in which one kind of mask and one kind of ion implantation energy are employed, the kind of mask and the kind of ion implantation energy can be provided both in plurality and the refractive indices can be gradually varied.

In the fabricating method of a mode matching element according to the fifteenth embodiment, the second lower cladding layer 2b and the second upper cladding layer 4b which are sufficiently thinner than the first lower cladding layer 2a and the first upper cladding layer 4a are formed, and the disordering due to ion implantation is performed to the second lower cladding layer 2b and the second upper cladding layer 4b to form the second lower cladding layer 2bb and the second upper cladding layer 4bb having varied refractive indices, whereby the mode matching element that can broaden the light intensity distribution in the X axis direction shown in the fourteenth embodiment is obtained. In the fabricating method of this embodiment, the second upper cladding layer 4bb and the second lower cladding layer 2bb having different refractive indices are formed by disordering due to the ion implantation and there are required no growth processes and etching processes for forming the second upper and lower cladding layers (2b, 4b) and the second upper and lower cladding layer (2bb, 4bb), and there arises no generation of notches due to the etching and regrowth processes, and these result in enhancing the formation precision of element and simplification of processes.

Embodiment 16.

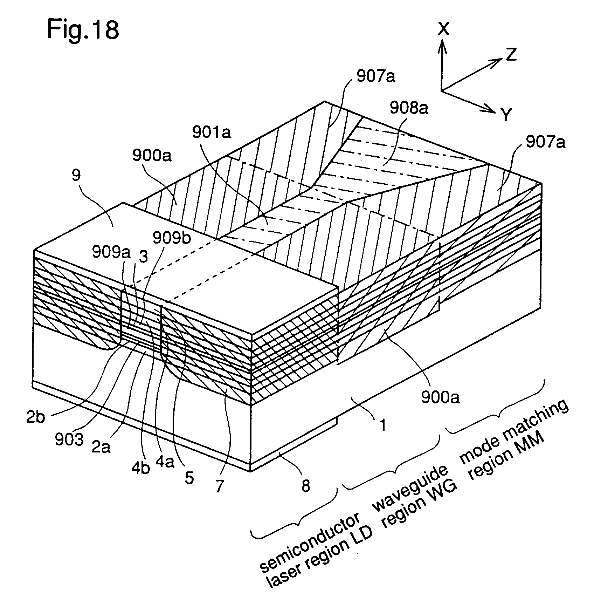

A description is given of an integrated semiconductor laser - waveguide - mode matching device with reference to the sixteenth embodiment with reference to figure 18.

In figure 18, the same reference numerals as those shown in figure 15 and 17 designate the same or corresponding portions. Reference numeral 900a designates a cladding portion of the waveguide region WG of the integrated semiconductor laser - waveguide - mode matching device according to the fourteenth embodiment. Reference numeral 901a designates a waveguide portion of the waveguide region WG, numeral 907a designates a cladding part of the mode matching region MM, and numeral 908a designates a waveguide portion of the mode matching region MM.

The integrated semiconductor laser - waveguide - mode matching device of this embodiment is produced by growing the first lower cladding layer 2a, the second lower cladding layer 2b, the distributed feedback type grading layer 903, the light guide layer 909a, the quantum well active layer 3, the light guide layer 909b, the second upper cladding layer 4b, the first upper cladding layer 4a, and the contact layer 5, and performing the disordering described below to the respective layers.

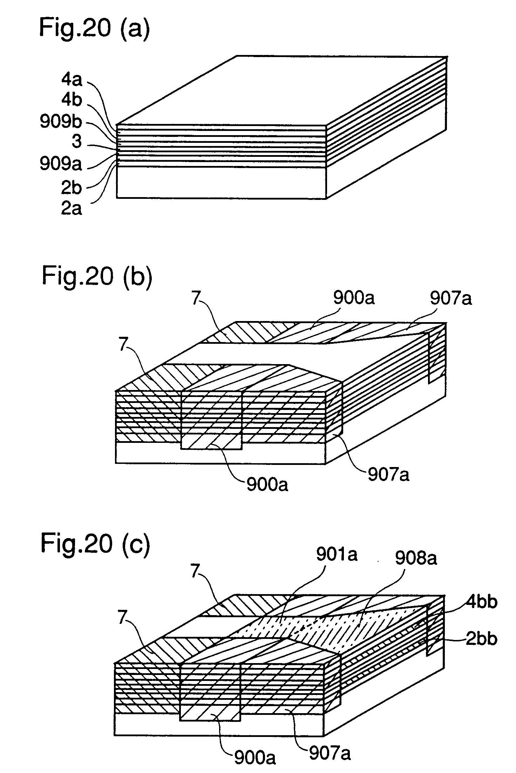

In this sixteenth embodiment, in the cladding portion 907a of the mode matching region MM, all the semiconductor crystals including the quantum well active layer 3 on the substrate 1 are disordered. On the other hand, in the waveguide portion 908a of the mode matching region MM, the quantum well layer 3 is not disordered and only the second upper cladding layer 4b and the second lower cladding layer 2b are disordered to be the second upper cladding layer 4bb and the second lower cladding layer 2bb, respectively (figure 20). The waveguide portion 908a of the mode matching region MM is broadened to be of a tapered configuration.

The waveguide region WG and the semiconductor laser region LD are disordered similarly as described in the eleventh embodiment.

A description of given of the function of this embodiment.

In this embodiment, in the mode matching region MM, the cladding portion 907a is formed with all the respective semiconductor layers being disordered, the waveguide portion 908a is formed with only the second upper and lower cladding layers (4b, 2b) being disordered, and the waveguide portion 908a is broadened in its rear end portion in a tapered configuration. Thereby, as described in the description of function of the mode matching element shown in the fifteenth embodiment, the light intensity distribution is broadened also in the X axis direction in the mode matching region. Further, that the rear end of the waveguide part 908a of the mode matching region MM is broadened is due to the same reason as that in the integrated semiconductor laser - waveguide - mode matching device according to the eleventh embodiment shown in figure 12, and thereby the light intensity distribution is broadened also in the Y axis direction. Thus, the light intensity distribution that is closer to a circular configuration is obtained.

In this sixteenth embodiment, the quantum well active layer 3 and the second upper and lower cladding layers 4b and 2b are all disordered in the cladding portion 907a of the mode matching region MM while only the upper and lower second cladding layers 4bb and 2bb are disordered without the quantum well layer 3 being disordered in the waveguide portion 908a of the mode matching region MM, and the rear portion of the mode matching region MM is broadened in a tapered configuration, thereby broadening the light intensity distribution for the light advancing to the mode matching region MM from the optical waveguide region WG in the both directions of the X axis direction and the Y axis direction. Therefore, the light spot can be connected with the optical element such as an optical fiber and LiNbO$_3$ which is arranged at its rear side with broadening the light spot, thereby obtaining an integrated semiconductor laser - waveguide - mode matching device that can suppress loss of light.

Embodiment 17.

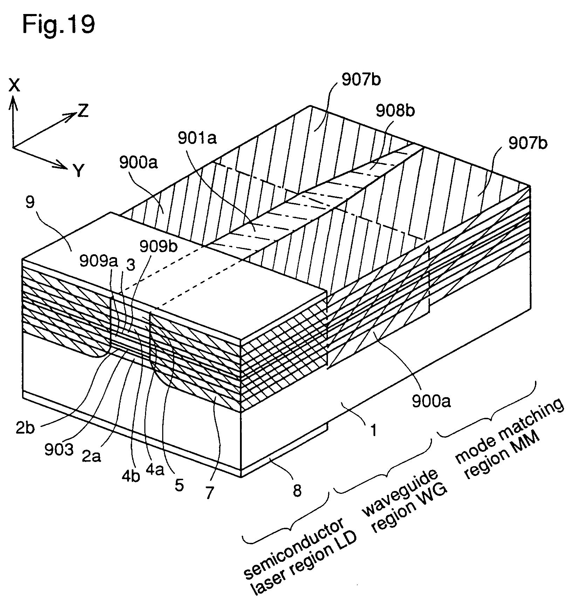

A description is given of an integrated semiconductor laser - waveguide - mode matching circuit with reference to figure 19.

In the figure 19, the same reference numerals as in figure 18 designate the same or corresponding portions. In this seventeenth embodiment, the cladding part 907b of the mode matching region MM is disordered for all the semiconductor crystals on the substrate 1. On the other hand, in the waveguide portion 908b of the mode matching region MM, only the second upper cladding layer 4b and the second lower cladding layer 2b are disordered to be the second upper cladding layer 4bb and the second lower cladding layer 2bb while the quantum well layer 3 is not disordered (figure 20). The rear end part of the waveguide part 908b of the mode matching region MM is narrowed in a tapered shape.

The waveguide region WG and the semiconductor laser region LD are disordered similarly as in the eleventh embodiment.

A description is given of the function of this embodiment.

In this embodiment, similarly in the sixteenth embodiment, waveguide part 908b of the mode matching region MM is formed by disordering the second upper and lower cladding layers (4bb, 2bb). In addition, in this seventeenth embodiment, the waveguide part 908b is narrowed in its rear end part in a tapered configuration. Thereby, as described in the description of function of the mode matching element in the fifteenth embodiment, the light intensity distribution is broadened also in the X axis direction in the mode matching region. The rear end of the waveguide portion 908b of the mode matching region MM is narrowed because of the same reason as that for the integrated semiconductor laser - waveguide - mode matching device of twelfth embodiment, so as to broaden the light intensity distribution also in the Y axis direction. Thereby, the light intensity distribution closer to a circular configuration is obtained.

In this seventeenth embodiment of the present invention, while all of the quantum well active layer 3 and the upper and lower second cladding layers 2b and 4b are disordered at the cladding portion 907 in the mode-matching region MM, only upper and lower second cladding layers 4bb and 2bb are disordered without the quantum well layer 3 being disordered for the waveguide portion 908b of the mode matching region MM, and the rear portion of the mode matching region MM is narrowed in a tapered configuration. Thereby, the light advancing to the mode matching region MM from the optical waveguide region WG is broadened for its light intensity distribution in both directions of the X and Y axis directions, and the connection of light to the optical elements such as optical fiber or LiNbO$_3$ arranged at rear side thereof can be conducted with the light spot being broadened in both directions of the X and Y axis directions, whereby the loss of light is suppressed.

Embodiment 18.

A description is given of a fabricating method of an integrated semiconductor laser - waveguide - mode matching circuit according to an eighteenth embodiment of the present invention with reference to figure 20.

In the figure, the same reference numerals as those in figures 14, 15, and 18 designate the same or corresponding portions.

A description is given of the fabricating method.

As shown in figure 20(a), on the substrate 1, a first lower cladding layer 2a, a second lower cladding layer 2b, a quantum well active layer 3, a second upper cladding layer 4b, a first upper cladding layer 4a, and a contact layer 5 are successively epitaxially grown.

Thereafter, similarly as the process in the thirteenth embodiment described with reference to figure 14, the disordering by ion implantation that is performed into the respective regions are carried out. More, particularly, as shown in figure 20(b), ion implantation is carried out to the regions 7, 900a, and 907a, similarly to that which is performed to the regions 7, 800, and 807 of figure 14. The configuration of the mask used here is broadened in the tapered configuration for its rear portion of the mode matching region MM as shown in the sixteenth embodiment, while it may be one that is narrowed in a tapered configuration for its rear portion as shown in the seventeenth embodiment.

As shown in figure 20(c), a mask having an aperture at the waveguide portion 901a of the mode matching region MM, and disordering employing ion implantation is carried out similarly as above. The disordering quantity then is made smaller than that of the cladding portion 907a. In the ion implantation of this region, the ion implantation is performed only to the two layers of the second upper cladding layer 4bb and the second lower cladding layer 2bb. The ion implantation quantity then is made approximately equal to those to the regions 900a and 907a serving as the cladding portions.

As shown in figure 20(c), a mask having an aperture at the waveguide portion 901a of the waveguide region WG, and the disordering employing ion implantation is carried out similarly as described above. The disordering quantity then is made the same or less than that which is performed to the entirety of the waveguide portion 908a of the mode matching region. Finally, the device to which the ion implantation is carried out is annealed, for example, at 800°C and for three hours, and thereafter electrodes 8 and 9 (figure 18 and figure 19) are formed on the upper and lower surfaces of the semiconductor laser region, thereby completing an integrated semiconductor laser - waveguide - mode matching device.

In this eighteenth embodiment, as similarly in semiconductor laser - waveguide - mode matching circuit of the thirteenth embodiment shown in figure 14, the width of the waveguide portion of the mode matching region MM and the refractive index of the waveguide portion are varied in tapered shapes so that the normalized frequency of the waveguide region WG and the normalized frequency of the mode matching region MM always coincide with each other. Thereby, as described above, the mode conversion can be carried out smoothly without generating multi modes.

The adjustment of the refractive index difference is realized by controlling the disordering quantity by varying the dose amount at the ion implantation in the Z axis direction similarly as in the seventh embodiment.

A description is given of the function of this embodiment.

In this eighteenth embodiment, in the waveguide portion and the cladding portion forming the waveguide of the integrated semiconductor laser - waveguide - mode matching circuit, respective portions are formed with different disordering quantities, and in the waveguide portion of the mode matching region, intensified disordering is performed only at the second upper cladding layer 4bb and the second lower cladding layer 2bb, whereby only one time crystal growth of semiconductor layers is sufficient and crystal growth process for forming the cladding portion is not required, resulting in easing fabrication of an integrated semiconductor laser - waveguide - mode matching circuit with high precision. Since the normalized frequencies of the waveguide region and the mode matching region are made coincide with each other, it is possible to carry out a mode conversion smoothly without generating multi modes. Furthermore, since the second upper cladding layer 4bb and the second lower cladding layer 2bb of the waveguide portion of the mode matching region are disordered, it is possible to broaden the light intensity distribution also in the epitaxial growth direction (X axis direction), and by making it the same as the light intensity distribution in the Y axis direction, it is possible to obtain a light intensity distribution closer to a circular configuration.

In the fabricating method of an integrated semiconductor laser - waveguide - mode matching circuit and the device fabricated, according to this eighteenth embodiment, it comprises a process of growing respective crystals of semiconductors including the second upper and lower cladding layers, a process of disordering the cladding portion of the above-described grown semiconductor layers, a process of disordering a desired portion of the waveguide portion, a process of disordering the second upper and lower cladding layers of the waveguide portion of the mode matching region, and a process of forming an electrode at the semiconductor laser region. Therefore, the semiconductor layers are fabricated by one time crystal growth process, and the crystal growth process for forming the cladding portion can be dispensed with, thereby simplifying the process. In addition, since the formation of the cladding portion is carried out by disordering due to the ion implantation, there arises no concavo-convex at the surface after the burying growth by etching, there are formed no notches at the surface, and the precision in photolithography of the mask pattern that is to be formed on the surface is increased, whereby the processing precision is largely improved. Since the normalized frequencies of the waveguide region and the mode matching region coincide with each other in this embodiment, the mode conversion can be carried out smoothly without generating multi modes, and loss of light at the transition from the semiconductor laser to the optical waveguide can be reduced. By disordering only the waveguide portions of the second upper and lower cladding layers in the mode matching region, it is possible to broaden the light also in the X axis direction, thereby performing the mode matching with the light intensity distribution having a configuration closer to a circular configuration.

## Claims

1. An optical waveguide having one or more quantum well layers comprising:
   said quantum well layer put between by cladding layers having smaller refractive indices than that of said quantum well layer; and
   said quantum well layer having a portion waveguiding light, which portion is put between by cladding layers having smaller refractive indices by disordering of said quantum well layer.

2. The optical waveguide (Figs. 3(a)-3(c)) of claim 1 forming a Y branch, a directional coupler, an X cross, a star coupler, or a combination of these.

3. A fabricating method of an optical waveguide comprising:
   forming a laminating layer structure including a lower cladding layer, at least one or more quantum well layers, and an upper cladding layer by crystal growing on a semiconductor substrate;
   forming an optical waveguide which is put between by disordered regions which are formed by disordering required portions of said laminating layer structure including said quantum well layer.

4. The fabricating method of an optical waveguide of claim 3 which comprises performing said disordering using a mask having a configuration selected among a Y branch, a directional coupler, an X cross, a star coupler, and a combination of these.

5. An integrated semiconductor laser - waveguide device (Fig. 4(a)) comprising a semiconductor laser region (300) having one or more quantum well active layers and a semiconductor waveguide region (310) having one or more quantum well layers wherein said quantum well active layer in said semiconductor laser region (300) and portions waveguiding light of said quantum well layer in said waveguide region (310) are put between by cladding layers having smaller refractive indices with said quantum well active layer and said quantum well layer disordered, and the waveguide portions in said waveguide region (310) having larger energy band gaps than that of said waveguide portion in said semiconductor laser region (300) by the disordering of said quantum well layer.

6. The integrated semiconductor laser - waveguide device (Fig 7(a)) of claim 5 wherein the waveguide portion of said waveguide region is disordered so as to gradually increase its energy band gap from the side of said semiconductor laser region.

7. The integrated semiconductor laser - waveguide device (Figs. 5(a)-5(b)) of claim 5 or 6 wherein the cladding portions (400) in said waveguide region are disordered so as to have their refractive indices larger than that of said cladding layer in said semiconductor laser region.

8. The integrated semiconductor laser - waveguide device (Figs. 5(a)-5(b)) of claim 7 wherein the cladding portions (400) in said waveguide region are disordered so as to gradually increase their refractive indices from the side of said semiconductor laser region.

9. The integrated semiconductor laser - waveguide device of any of claims 5 to 8 wherein the normalized frequency of the waveguide portion in said disordered waveguide region and that of the waveguide portion in said semiconductor laser region are equal to each other.

10. The integrated semiconductor laser - waveguide device of any of claims 5 to 9 wherein the lower cladding layer or the upper cladding layer in said semiconductor laser region includes a grating layer of distribution feedback type.

11. The integrated semiconductor laser - waveguide device (Fig. 10) of any of claims 5 to 9 having a groove (604) that has a vertical side surface between said semiconductor laser region and said waveguide region.

12. The integrated semiconductor laser - waveguide device (Fig. 23) of claim 11 wherein said groove (604) is filled with materials (606) having smaller refractive indices than the effective refractive index of the active layer (3) of said semiconductor laser.

13. A fabricating method of an integrated semiconductor laser - waveguide device (Fig. 9) comprising:
    successively growing a lower cladding layer (2), a quantum well layer (3), an upper cladding layer (4), and a contact layer (5) on a semiconductor substrate (1);
    disordering a portion serving as a cladding portion (500) of said quantum well layer (3) by performing ion implantation and diffusion to portions serving as cladding portions (500) of said semiconductor laser region and said waveguide region; and
    disordering a waveguide portion (501) of said quantum well layer (3) to a ratio smaller than that of said cladding portion (500) by performing ion implantation and diffusion to a waveguide portion (501) of said waveguide region.

14. The fabricating method of an integrated semiconductor laser - waveguide device of the claim 13 (Fig. 9) wherein the process of disordering said cladding portion (500) or said waveguide portion (501) comprises disordering said quantum well layer (3) by performing ion implantation into a portion where the disordering is to be performed of said cladding portion (500) or said waveguide portion (501), and gradually disordering the remaining region other than a portion where the disordering is to be performed by performing ion implantation and diffusion once or several times.

15. An integrated semiconductor laser - waveguide - photodiode device (Figs. 11(a)-11(d)) comprising:
    a semiconductor laser region (700) having one or more quantum well active layers, a waveguide region (710) having one or more quantum well layers, a photodiode region (720) which is formed successively to the semiconductor laser region (700) and the waveguide region (710) and functions as a photodiode with a reverse bias applied to the pn junction in the layers including the quantum well layer, which are commonly formed on a substrate (1);
    both sides of portions waveguiding light, of said quantum well active layer in the semiconductor laser region (700) and said quantum well layer in the waveguide region (710) are sandwiched by cladding portions having smaller refractive indices by disordering said quantum well active layer and said quantum well layer; and
    the energy band gap of the waveguide portion in said waveguide region (710) is larger than that of the waveguide portion in said semiconductor laser region (700) due to the disordering.

16. A method of fabricating an integrated semiconductor laser - waveguide - photodiode device (Figs. 11(a)-11(d)) having a semiconductor laser region (700), a waveguide region (710), and a photodiode region (720) on a same substrate (1) comprising:
    successively growing a lower cladding layer (2), a quantum well layer (3), an upper cladding layer (4), and a contact layer (5) on said substrate (1);
    disordering said quantum well layer (3) of said cladding portion in the semiconductor laser region (700) and in the waveguide region (710) by performing ion implantation and diffusion to the cladding portion of those regions;
    disordering the quantum well layer (3) in said waveguide region (710) in a smaller ratio than that of the cladding portion by performing ion implantation and diffusion to the waveguide portion in said waveguide region (710);
    forming respective lower electrodes or a common lower electrode (704) in said semiconductor laser region (700) and in the photodiode region (720); and
    forming upper electrodes (724a) in said semiconductor laser region (700) and in said photodiode region (720), respectively.

**17.** An integrated semiconductor laser - waveguide - mode matching circuit device (Fig. 12 or 13) comprising:

a semiconductor laser region having one or more quantum well active layers, a waveguide region having one or more quantum well layers, and a mode matching region having at least one or more quantum well layers and performing mode-matching, which are formed integrated on a substrate (1);

both sides of the portions waveguiding light, of said quantum well active layer in said semiconductor laser region and of said quantum well layers in the waveguide region and in the mode matching region being sandwiched by the cladding portions (807 or 807a) having smaller refractive indices due to the disordering of said quantum well active layer and said quantum well layer;

the waveguide portions in said waveguide region and in said mode matching region (801 and 808, or 801a and 808a) being disordered so as to have larger energy band gaps than that of the waveguide portion in said semiconductor laser region; and

the waveguide portion (808 or 808a) in said mode matching region being formed in a tapered shape.

**18.** The integrated semiconductor laser - waveguide - mode matching circuit device (Fig. 18 or 19) of claim 17, further comprising:

said device including a first lower cladding layer (2a), a second lower cladding layer (2b), said quantum well layer (3), a second upper cladding layer (4b), and a first upper cladding layer (4a);

said second upper cladding layer (4b) and said second lower cladding layer (2b) comprising materials having smaller refractive indices than that of said first upper cladding layer (4a) and that of said first lower cladding layer (2a), respectively; and

additionally to said respective disordered portions, only said second upper cladding layer (4b) and the second lower cladding layer (2b) of said waveguide portion (908a or 908b) in the mode matching region being intensively disordered.

**19.** The integrated semiconductor laser - waveguide - mode matching circuit device of claim 17 or 18 wherein the waveguide portion in said mode matching region is formed expanding in a tapered shape.

**20.** The integrated semiconductor laser - waveguide - mode matching circuit device of claim 17 or 18 wherein the waveguide portion in said mode matching region is formed being narrowed in a tapered shape.

**21.** The integrated semiconductor laser - waveguide - mode matching circuit device of claim 17 or 18 wherein the normalized frequency of the waveguide in said waveguide region and that in said mode matching region are equal to each other.

**22.** The integrated semiconductor laser - waveguide - mode matching circuit device of claim 21 wherein the waveguide portion in said mode matching region is expanded in a tapered shape.

**23.** The integrated semiconductor laser - waveguide - mode matching circuit device of claim 21 wherein the waveguide portion in said mode matching region is narrowed in a tapered shape.

**24.** A method for fabricating an integrated semiconductor laser - waveguide - mode matching circuit device (Fig. 14) having a semiconductor laser region, a waveguide region, and a mode matching region on a substrate (1) including:

successively growing a lower cladding layer (2), a quantum well layer (3), an upper cladding layer (4), and a contact layer (5) on a semiconductor substrate (1);

performing ion implantation to portions serving as cladding portions (800), of said semiconductor laser region and said waveguide region thereby to disorder said portion (800) of said quantum well layer (3);

after forming a mask having a taper-shaped aperture at a portion serving as the cladding portion (807) in said mode matching region, performing ion implantation through this mask, thereby to disorder said quantum well layer (3) of said portion (807);

performing ion implantation to the waveguide portion (801) in said waveguide region, thereby to disorder said quantum well layer (3) of said waveguide portion (801) in a smaller ratio than the disordering of said cladding portion (800);

after forming a mask having a taper-shaped aperture at a portion serving as a waveguide portion (808) in said mode matching region, performing ion implantation through this mask, thereby to disorder said quantum well layer (3) of the waveguide portion (808) in a smaller ratio than the disordering of said cladding portion (807).

**25.** The fabricating method of an integrated semiconductor laser - waveguide - mode matching circuit device of claim 24 (Fig. 20) wherein:

the above-described growth process is a process of growing said first lower cladding layer (2a), said second lower cladding layer (2b), said quantum well layer (3), said second upper cladding layer (4b), said first upper cladding layer (4a), and said contact layer (5) on the substrate (1), where said second upper cladding layer (4b) and said second lower cladding layer (2b) have different refractive indices from those of said first upper cladding layer (4a) and said first lower cladding layer (2a), respectively; and

the process of disordering the waveguide portion (907a) in said mode matching region includes intensively disordering only both of said second upper cladding layer (4b) and said second lower cladding layer (2b), additionally to disordering said disordering.

26. The fabricating method of an integrated semiconductor laser - waveguide - mode matching circuit device of claim 24 or 25 wherein the process of disordering the mode matching region is the process of disordering the same so that the normalized frequencies in said waveguide region and in said mode matching region coincide with each other.

27. A mode matching element for converting the mode of input light to output light (Fig. 15(a)) comprising:
a first lower cladding layer (2a), a second lower cladding layer (2b), a light guiding layer (909a), a quantum well layer (3), a light guiding layer (909b), a second upper cladding layer (4b), and a first upper cladding layer (4a) which are successively formed on the substrate (1), where said second upper cladding layer (4b) and said second lower cladding layer (2b) have different refractive indices from those of said first upper cladding layer (4a) and said first lower cladding layer (2a), respectively;
a cap layer (911) formed on the center of the upper cladding layer (4a) and having a larger refractive index than that of said first upper cladding layer (4a);
current blocking layers (910) provided sandwiching said cap layer (911) at both sides on the first cladding layer (4a) and having a smaller refractive index than that of said first cladding layer (4a);
a contact layer (5) provided on said upper first cladding layer (4a) and the current blocking layer (910); and
portions of said second upper cladding layer (4bb) and said second lower cladding layer (2bb) being disordered.

28. A method for fabricating a mode matching element for converting the mode of input light to that of output light (Figs. 17(a)-17(b)) comprising:
successively growing a first lower cladding layer (2a), a second lower cladding layer (2b), a light guiding layer (909a), a quantum well layer (3), a light guiding layer (909b), a second upper cladding layer (4b), a first upper cladding layer (4a), a cap layer (911), where said second upper cladding layer (4b) and said second lower cladding layer (2b) have different refractive indices from those of said first upper cladding layer (4a) and said first lower cladding layer (2a), respectively;
after etching both sides of said cap layer (911), growing blocking layers (910) at both sides thereof, and growing a contact layer (5) thereon;
performing ion implantation to said second lower cladding layer (2b) and said second upper cladding layer (4b); and
performing annealing, thereby to disorder said second upper cladding layer (4b) and said second lower cladding layer (2b).

## Fig.1 (a)

## Fig.1 (b)

## Fig.1 (c)

## Fig.1 (d)

growth direction

AlGaAs
light confine
GaAs well
AlGaAs barrier
80 Å    GaAs well
60 Å    AlGaAs barrier
GaAs well
700 Å    AlGaAs
light confine

0        0.2
solid phase ratio of Al

ion
implantation ⟹

3a

AlGaAs

0        0.2
solid phase ratio of Al

EP 0 696 747 A2

Fig.2 (a)

Fig.2 (d)

Fig.2 (b)

Fig.2 (e)

Fig.2 (c)

26

## Fig.3 (a)

200B
200a
200A
200c
200b
200

## Fig.3 (b)

210b
210B
1/2 λ2    1/2 λ2    λ2
210d
1/2 λ2
210a
λ1,λ2    1/2 λ2    1/2 λ2
λ1
λ1+1/λ2
210c
210A    210C1    210C2
210

## Fig.3 (c)

λ1    1/2 (λ1+λ2)
220A
220B
λ2    1/2 (λ1+λ2)
220C
220

## Fig.4 (a)

semiconductor
laser region LD

wave synthesizer
region WG

## Fig.4 (b)

## Fig.4 (c)

Fig.5 (a)

Fig.5 (b)

semiconductor
laser region LD

waveguide region WG

## Fig.6 (a)

## Fig.6 (b)

## Fig.6 (c)

## Fig.7 (a)

## Fig.7 (b)

Fig.8 (a)

Fig.8 (b)

## Fig.9 (a)

## Fig.9 (b)

## Fig.9 (c)

## Fig.9 (d)

## Fig.10

semiconductor
laser region LD

waveguide region WG

Fig.11 (a)

semiconductor
laser region LD

waveguide
region WG

photodiorde
region PD

Fig.11 (b)                    Fig.11 (c)

Fig.11 (d)

semiconductor
laser region LD

waveguide
region WG

photodiorde
region PD

Fig.12

## Fig.13 (a)

## Fig.13 (b)

Fig.14 (a)

Fig.14 (b)

Fig.14 (c)

Fig.14 (d)

Fig.14 (e)

Fig.14 (f)

Fig.14 (g)

## Fig.15 (a)

## Fig.15 (b)

refractive index

light intensity distribution

## Fig.15 (c)

refractive index

light intensity distribution

Fig.16

Fig.17 (a)

Fig.17 (b)

Fig.18

Fig.19

Fig.20 (a)

4a
4b
909b
3
909a
2b
2a

Fig.20 (b)

7          900a          907a
7
900a          907a

Fig.20 (c)

7          901a          908a
7                                4bb
2bb
900a          907a

Prior Art

Fig.21 (a)

Fig.21 (b)

Fig.21 (c)

Fig.21 (d)

Fig.22   Prior Art

# Fig.23

semiconductor
laser region LD

waveguide region WG